(19) Europäisches Patentamt
European Patent Office
Office européen des brevets

(11) **EP 2 385 627 B1**

(12) **EUROPÄISCHE PATENTSCHRIFT**

(45) Veröffentlichungstag und Bekanntmachung des Hinweises auf die Patenterteilung:
**26.09.2018 Patentblatt 2018/39**

(21) Anmeldenummer: **11165027.1**

(22) Anmeldetag: **06.05.2011**

(51) Int Cl.:
***H03K 17/10*** *(2006.01)* *H03K 19/013* *(2006.01)*
***H03K 17/041*** *(2006.01)*

(54) **Durchbruchsspannungsverdopplerschaltung**

Breakdown voltage doubler circuit

Circuit de doubleur de tension de claquage

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.05.2010 EP 10162300**

(43) Veröffentlichungstag der Anmeldung:
**09.11.2011 Patentblatt 2011/45**

(73) Patentinhaber: **Technische Universität Dresden**
**01069 Dresden (DE)**

(72) Erfinder:
• **Knochenhauer, Christian**
**01159, Dresden (DE)**
• **Ellinger, Frank**
**01069, Dresden (DE)**
• **Scheytt, Christoph**
**15234, Frankfurt (Oder) (DE)**

(74) Vertreter: **Lippert Stachow Dresden**
**Krenkelstraße 3**
**01309 Dresden (DE)**

(56) Entgegenhaltungen:
**US-A1- 2005 258 866     US-A1- 2009 245 813**

• **GALAL S ET AL: "10-Gb/s limiting amplifier and laser/modulator driver in 0.18-/spl mu/m CMOS technology", IEEE JOURNAL OF SOLID-STATE CIRCUITS, IEEE SERVICE CENTER, PISCATAWAY, NJ, USA, Bd. 38, Nr. 12, 1. Dezember 2003 (2003-12-01), Seiten 2138-2146, XP011104262, ISSN: 0018-9200, DOI: 10.1109/JSSC.2003.818567**
• **SAM MANDEGARAN ET AL: "A Breakdown Voltage Multiplier for High Voltage Swing Drivers", IEEE JOURNAL OF SOLID-STATE CIRCUITS, IEEE SERVICE CENTER, PISCATAWAY, NJ, USA, Bd. 42, Nr. 2, 1. Februar 2007 (2007-02-01), Seiten 302-312, XP011161675, ISSN: 0018-9200, DOI: 10.1109/JSSC.2006.889390**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Durchbruchsspannungsverdopplerschaltung mit einer aus gestapelten Transistoren bestehenden Ausgangsstufe, die eine Spannung bereitstellt, welche die Durchbruchsspannung jedes einzelnen Ausgangstransistors der Schaltung übersteigt. Die Erfindung betrifft außerdem ein integriertes Schaltungsbauelement mit einer solchen Schaltung.

Breitbandverstärker mit hohem Verstärkungsfaktor, hoher Ausgangsleistung und niedriger Leistungsaufnahme stellen Schlüsselelemente für sehr schnelle Elektronik dar. Der breite Anwendungsbereich solcher Bauelemente umfasst beispielsweise Breitband-Messverstärker oder Modulatortreiber für sehr schnelle optische Kommunikationssysteme. Letztere stellen besondere Herausforderungen an ein kostengünstiges und energieeffizientes Design, da die meisten optischen Modulatoren für den Hochgeschwindigkeitsbetrieb Treiberspannungshübe von ungefähr 2 bis 3 V benötigen.

Mit der fortlaufenden Miniaturisierung von Bauelementen haben sich die Durchbruchsspannungen moderner Halbleitertechnologien ständig vermindert und sind somit in das Interesse von Entwicklern für Hochfrequenzschaltkreise gerückt. Der Durchbruch von Bipolartransistoren wurde eingehend untersucht und bei Grens, C.M., Cressler, J.D., and Joseph, A.J.,: "On Common- Base Avalanche Instabilities in SiGe HBTs", Electron Devices, IEEE Transactions on, 2008, 55, (6), S. 1276-1285, beschrieben. Es handelt sich dabei - im Gegensatz zum Durchbruch des Gate-Oxids in MOS-Transistoren - um einen kontinuierlichen, nicht notwendigerweise zerstörenden Prozess, der mit einem Anstieg des Kollektor-Basis-Lawinenstroms mit zunehmender Kollektor-Basis-Spannung $V_{CB}$ beginnt, d. h. mit zunehmender Kollektor-Emitter-Spannung $V_{CE}$. Der Durchbruch tritt per Definition dann auf, wenn dieser Lawinenstrom (aus der Basis) gleich dem Basis-Strom in die Basis hinein) ist. In diesem Fall wird der Basis-Gesamtstrom null. Die übliche Durchbruchcharakterisierungsspannung $BV_{CEO}$ (BV für engl. Breakdown Voltage) ist daher für Konfigurationen mit offener Basis gültig. Der Durchbruchstrom führt nur dann zu Instabilität, wenn nicht verhindert wird, dass er wieder in die Basis fließt, was zu einer Verstärkung und zum Entstehen einer positiven Rückkopplung beiträgt. Eine Möglichkeit, dies zu verhindern besteht darin, die Basis von Transistoren, bei denen ein Durchbruch zu befürchten ist, so niederohmig wie möglich zu gestalten. Folglich kann der Transistor bis zu einer Kollektor-Emitter-Spannung $BV_{CEX} > BV_{CEO}$ betrieben werden. Man vergleiche Veenstra, H., Hurkx, G.A.M., van Goor, D., Brekelmans, H., und Long, J.R.; "Analyses and design of bias circuits tolerating output voltages above BVCEO", Solid-State Circuits, IEEE Journal of, 2005, 40, (10), S. 2008-2018.

Während sich aufgrund der anhaltenden Miniaturisierung von Bauelementen in modernen Halbleitertechnologien die Betriebsfrequenzen von Transistoren ständig erhöhen, wird die maximale Ausgangsleistung von Breitbandverstärkern durch die geringeren Durchbruchsspannungen der Bauelemente begrenzt. Derzeit kommen für die meisten Treiber mit hohen Spannungshüben III-V Halbleitertechnologien zur Anwendung, die höhere Durchbruchsspannungen aufweisen, aber sehr kostenintensiv sind.

Frühere Arbeiten zu Treibern mit hohen Spannungshüben, die in kosteneffizienten Siliziumtechnologien ausgeführt sind, waren hauptsächlich darauf konzentriert, bei langsameren Technologien mit einer höheren Durchbruchsspannung die Geschwindigkeit zu erhöhen. Man vergleiche beispielsweise Li, D.U., und Tsai, C.M.: 'Efficient breakdown voltage doubler for 10 Gbit/s SiGe modulator drivers', Electronics Letters, 2005, 41, (3), S. 126-127. Die bisher präsentierten Lösungen sind jedoch nicht sehr schnell und/oder verbrauchen sehr viel Leistung.

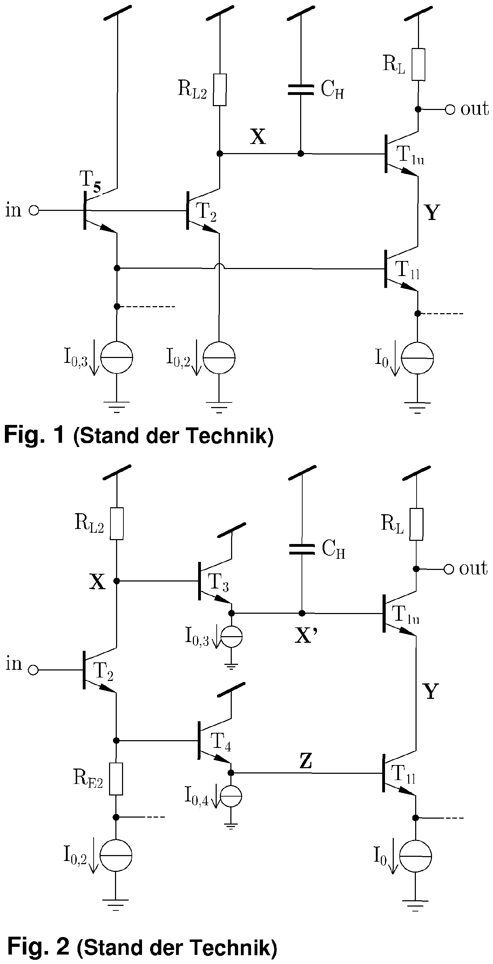

In "A Breakdown Voltage Multiplier for High Voltage Swing Drivers", Solid-State Circuits, IEEE Journal of, 2007, 42, (2), S. 302-312, und in der US 7,321,242 B2, sowie der US 2005/0258866 A1 von Mandegaran et al. ist eine Durchbruchsspannungsverdoppler-Topologie beschrieben, bei der die Ausgangstransistoren gestapelt sind. Die Grundidee des Durchbruchsspannungsverdopplers (BVD, für engl. Breakdown Voltage Doubler) von Mandegaran besteht darin, die Ausgangsspannung gleichmäßig auf zwei gestapelte Ausgangstransistoren zu verteilen, um jede einzelne Kollektor-Emitter-Spannung niedrig zu halten. Eine Schaltungsrealisierung mit diesem Prinzip liefert einen Ausgangshub von 3,8 V bei 10 Gbit/s. Ein vereinfachtes Schema einer solchen Ausgangsstufe ist in Fig. 1 gezeigt. Der Einfachheit halber ist dabei lediglich die linke Hälfte der differentiellen Schaltungsstruktur gezeigt, die gestrichelten Linien stellen die Verbindungen zu den entsprechenden Knoten der spiegelsymmetrischen rechten Hälfte dar. Das Konzept besteht darin, die Treiberstufe, bestehend aus $T_2$ und $R_{L2}$ in solcher Weise zu dimensionieren, dass die Spannung am Punkt X sicherstellt, dass die Ausgangsspannung gleichmäßig auf die Ausgangstransistoren $T_{1u}$ und $T_{1l}$ verteilt wird. Dies ist möglich, weil sich die Punkte X und Y aufgrund der festen Basis-Emitter-Spannung des Bipolartransistors in etwa parallel bewegen. Die Leistungsaufnahme der Schaltung aus Fig. 1 beträgt 3,6 W.

Diese Schaltung von Mandegaran aus Fig. 1 hat zwei Hauptnachteile: Erstens ist sie mit 10 Gbit/s nicht sehr schnell. Stand der Technik für optische Modulatoren sind 40 Gbit/s, und im Labor sind bereits 100 Gbit/s verfügbar. Zweitens verbraucht sie sehr viel Leistung. Begründet sind diese Nachteile darin, dass der obere Pfad durch das RC-Glied verlangsamt wird und dass der untere Pfad unkompensiert ist und viel Energie verbraucht. Der Hauptkompromiss zwischen Leistungsaufnahme und Geschwindigkeit ist an dem Knoten X zu lokalisieren. Die hohe Kapazität an diesem Knoten (großer Ausgangstransistor und $C_H$) erfordert, dass $R_{L2}$ klein ist, um ein schnelles Schalten von $T_2$ zu ermöglichen. Andererseits erfordert der hohe Spannungshub bei X (Hälfte des Ausgangsspannungshubs) einen hohen Betriebsstrom

durch $T_2$. Leistungsverbrauch und Geschwindigkeit sind also gekoppelt, d.h. je größer der Transistor, desto schneller ist er am Ausgang, aber desto höher ist der Verbrauch. Darüber hinaus verbraucht die doppelte Treiberstufe, bestehend aus $T_2$ und $T_5$, zusätzlich Energie.

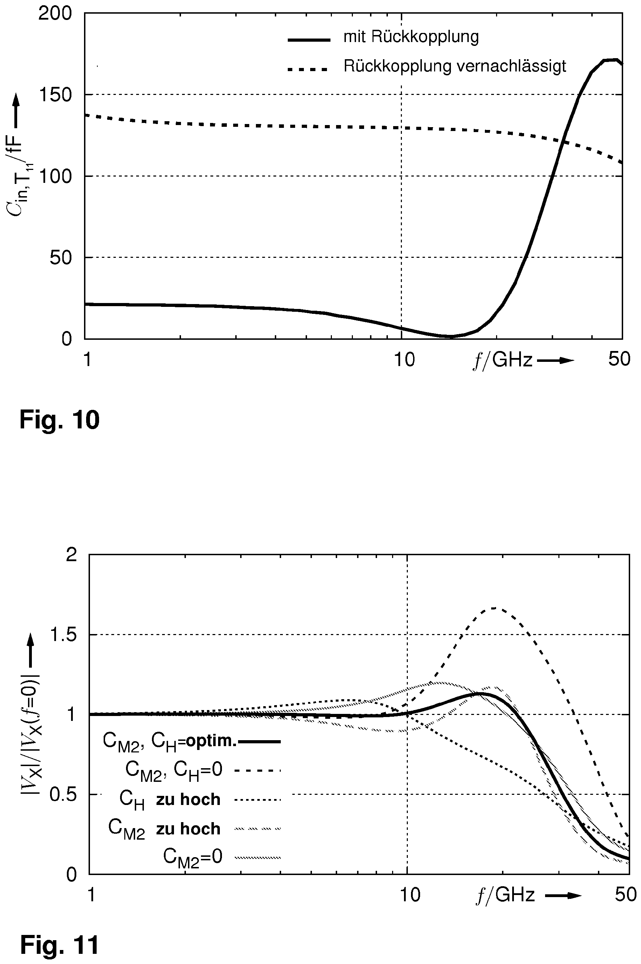

In einer modifizierten Durchbruchsspannungsverdoppler-Topologie, wie in Fig. 2 dargestellt, sind in beide Signalpfade Emitterfolger eingefügt, die das RC-Glied aufteilen und dadurch den oberen Pfad nicht verlangsamen. Der Knoten X ist von den Transistoren getrennt und die Treiberstufen aus Fig. 1 sind zu einer einzelnen Stufe zusammengefasst. Durch die Basis-Emitter-Kapazität $C_{BE}$ des unteren Ausgangstransistors $T_{1l}$ und den Ausgangswiderstand von $T_4$ wird ein RC-Glied mit der Grenzfrequenz $f_G = 1/2\pi RC$ gebildet. Da $T_{1l}$ wegen der geforderten Ausgangsspannung bzw. wegen des hohen Kollektor-Emitter-Stromes groß sein muss, ist auch $C_{BE}$ groß. Um die Schaltung zu beschleunigen, d.h. $f_G$ groß zu machen, bleibt nur die Möglichkeit, den Ausgangswiderstand von $T_4$ zu verkleinern, und dafür muss $I_{0,4}$ vergrößert werden, wodurch sich ein hoher Stromverbrauch ergibt. Gleiches gilt für die vorangehende Stufe. Das gleiche RC-Problem besteht prinzipiell auch im oberen Pfad. Allerdings liegt die Basis-Emitter-Kapazität $C_{BE}$ des oberen Ausgangstransistors $T_{1u}$ nicht direkt sondern über $T_{1l}$ an Masse. Aus diesem Grunde ergibt sich am Punkt X in Fig. 1 bzw. X' in Fig. 2 eine viel zu hohe Bandbreite und ein Überschwingen, das zu Signalverzerrung führt. Deshalb ist in die Schaltungen von Mandegaran eine Kompensationskapazität $C_H$ eingefügt, welche die Bandbreite verringern soll. Dennoch ist immer noch eine hohe Signalverzerrung zu verzeichnen, wie aus der Vergleichskurve in Fig. 11 für $C_{M2}=0$ zu ersehen ist. Es ist offensichtlich, dass die beiden zusätzlichen Stufen zusätzlich Energie verbrauchen, wenngleich durch die Verkleinerung der Treiberstufe von $T_5$ und $T_2$ in Fig. 1 auf lediglich $T_2$ in Fig. 2 auch wieder Energie eingespart wird.

Allgemein wird beim Entwurf von sehr schnellen, breitbandigen integrierten Schaltungen der Betriebsbereich von Bipolartransistoren durch zwei Effekte begrenzt, die mit der Kollektor-Emitter-Spannung $V_{CE}$ zusammenhängen: Sättigung, wenn die Kollektor-Emitter-Spannung $V_{CE}$ zu niedrig ist, und Durchbruch, wenn $V_{CE}$ zu hoch ist, wie bereits im einleitenden Teil beschrieben. Das Funktionsprinzip und die Basisspannungspegel im Durchbruchsspannungsverdoppler (BVD) wurden von Mandegaran diskutiert und gelten sowohl für die Schaltung aus Fig. 1 wie auch aus Fig. 2. Darüber hinaus haben die Erfinder eine Reihe zusätzlicher Gleichstrom-Einschränkungen analysiert, die sich bei der Schaltung in Fig. 2 aus der Verknüpfung des Signalpfades durch $T_3$, nachfolgend als "oberer Pfad" bezeichnet, und durch $T_4$, nachfolgend als "unterer Pfad" bezeichnet, ergeben.

Die Dimensionierung der Ausgangsstufe ergibt sich nahezu von selbst, wenn gleichzeitig durch beide gestapelten Ausgangstransistoren der obere Grenzwert $V_{CE,max} = BV_{CEX}$ und der untere Grenzwert $V_{CE,min}=V_{CE,sat}$ eingehalten werden sollen. Wenn die Ausgangstransistoren aus Gründen der Geschwindigkeit nicht vollständig ausgeschaltet werden, d. h. im Zustand "off" ein Strom $I_m>0$ durch $R_L$ fließt, so ergibt sich aus dem Kirchhoff'schen Spannungsgesetz für die Ausgangsstufen:

$$\Delta V_{out} = V_{out,on} - V_{out,off}$$

$$= V_{cc} - 3V_{CE,sat} - R_L \cdot I_m = 2\left(V_{CE,max} - V_{CE,sat}\right) = R_L\left(I_{0,1} - I_m\right) \qquad (1).$$

Dabei bezieht sich "off" auf den Zustand der Ausgangstransistoren, $I_{0,1}$ bezeichnet den Querstrom der Ausgangsstufe, und $R_L$ den Wert des Lastwiderstandes.

(Die Transistoren $T_{1u}$, $T_{1l}$ und $T_2$ auf der einen Seite der Schaltung werden parallel an- und ausgeschaltet, nur die Transistoren der Kollektorstufen bleiben immer "on". Somit bezieht sich "off" auf den Zustand, bei dem $T_{1u}$, $T_{1l}$ und $T_2$ nicht leitend sind und am Ausgang sowie am Knoten X das Potential "high" ist. Stellen wir in Rechnung, dass $V_{CE,max}$ und $V_{CE,sat}$ Parameter darstellen, die durch die Technologie bestimmt sind, dass $I_m$ eher klein ist und $R_L$ in der Praxis auf 50 Ω festgelegt wird, um eine Ausgangsanpassung für niedrige Frequenzen sicherzustellen, so stehen die Versorgungsspannung Vcc und der Querstrom $I_{0,1}$ der Ausgangsstufe praktisch fest, wenn die Ausgangsamplitude $\Delta V_{out}$ gegeben ist durch

$$I_{0,1} \cong \frac{\Delta V_{out}}{R_L} = \frac{3\,\text{V}}{50\,\Omega} = 60\,\text{mA} \qquad (2).$$

Die Treiberstufe, bestehend aus $T_2$ und $R_{L2}$ wird ebenfalls nahezu vollständig durch Gleichstrom-Einschränkungen bestimmt. Stellt man die Maschengleichungen für den oberen Pfad $T_3$ für die Zustände "on" bzw. "off" auf, so erhält man

$$R_{L2} = \frac{V_{X,on} - V_{X,off}}{I_{TX,on} - I_{Tx,off}} = \frac{V_{CE,max} - V_{CE,sat} + V_{BE,on} - V_{BE,off}}{2\left(I_{0,2} - I_{m,2}\right)} \qquad (3).$$

Es ist zu beachten, dass die Stufen differentiell sind, daher multiplizieren sich die Ströme um einen Faktor 2. Die Amplitude am Knoten X muss exakt geregelt werden. Dies kann geeigneterweise durch Stromrückkopplung über $R_E$ erfolgen, mit dem angenehmen Nebeneffekt, dass sich die Bandbreite am Knoten X erhöht. Die Gleichspannungsverstärkung der Stufe beträgt dann

$$v = \frac{g_{m2}R_{L2}}{1 + g_{m2}R_{E2}} = \frac{V_{X,on} - V_{X,off}}{V_{in,on} - V_{in,off}} \qquad (4)$$

Da die DC-Eingangspegel im Zustand "on" bzw. "off" ebenfalls vollständig durch die von der Technologie abhängigen Werte für die Basis-Emitter-Spannung $V_{BE}$ bestimmt werden, ist auch $R_{E2}$ durch Gleichstrom-Einschränkungen festgelegt:

$$R_{E2} = \frac{V_{BE,on} - V_{BE,off} - V_T}{I_{0,2}} \qquad (5)$$

Wenngleich sich die Transistoren im Allgemeinen nicht vollständig linear verhalten, wie in dieser Grobkalkulation angenommen, so macht diese doch deutlich, dass dem Entwickler sehr wenige Freiheitsgrade verbleiben, wenn es um die Optimierung der Geschwindigkeit geht. Tatsächlich kann der Entwickler lediglich den Querstrom $I_{0,2}$ der Treiberstufe und die Restströme $I_m$ und $I_{m2}$ frei wählen. Aufgabe der Erfindung ist es, eine verbesserte Schaltungstopologie für einen Durchbruchsspannungsvervielfacher aufzuzeigen, die schneller ist und weniger Leistung verbraucht.

Erfindungsgemäß wird eine Durchbruchsspannungsverdopplerschaltung nach Anspruch 1 oder nach Anspruch 2 zur Verfügung gestellt. Diese Schaltung stellt eine symmetrische Schaltung mit einer ersten und einer zweiten Schaltungshälfte dar, wobei jede Schaltungshälfte umfasst: eine Ausgangsstufe mit einem ersten und einem zweiten Ausgangstransistor in einer derart gestapelten Konfiguration, dass der Emitter des ersten Ausgangstransistors mit dem Kollektor des zweiten Ausgangstransistors verbunden ist; eine Signalteilerstufe die mit dem Eingang verbunden ist und über einen ersten Signalpfad mit dem ersten Ausgangstransistor und über einen zweiten Signalpfad mit dem zweiten Ausgangstransistor verbunden ist; wobei die Schaltung dafür ausgelegt ist, eine Ausgangsspannung gleichmäßig auf die beiden gestapelten Ausgangstransistoren zu verteilen, um eine Spannung bereitzustellen, welche die Durchbruchsspannung jedes einzelnen der Ausgangstransistoren übersteigt. Die erfindungsgemäße

Durchbruchsspannungsverdopplerschaltung ist dabei in einer Ausführungsform dadurch gekennzeichnet, dass der obere Signalpfad der ersten Schaltungshälfte mit dem unteren Signalpfad der zweiten Schaltungshälfte über einen ersten Koppelpfad eines Koppelnetzwerks gekoppelt ist und der untere Signalpfad der ersten Schaltungshälfte der Schaltung mit dem oberen Signalpfad der zweiten Schaltungshälfte der Schaltung über einen zweiten Koppelpfad eines Koppelnetzwerks gekoppelt ist. In einer weiteren Ausführungsform der Durchbruchsspannungsverdopplerschaltung sind in beiden Schaltungshälften jeweils die Signalpfade vor den Basen der Ausgangstransistoren vertikal gekoppelt, d.h. in jeder Schaltungshälfte ist der obere Signalpfad mit dem unteren Signalpfad gekoppelt.

Durch die Kopplung der beiden Signalpfade vor den Ausgangstransistoren wird eine signifikante Beschleunigung des unteren Pfades und eine Kompensation der Umladeströme im oberen Pfad bewirkt.

Die ersten Signalpfade können jeweils eine erste Signalverarbeitungsstufe enthalten. Die zweiten Signalpfade können jeweils eine zweite Signalverarbeitungsstufe enthalten.

In einer bevorzugten Ausführungsform umfasst die erste Signalverarbeitungsstufe mindestens einen ersten Emitterfolger, dessen Basis mit dem Kollektor des Eingangstransistors gekoppelt ist und dessen Emitter mit der Basis des ersten Ausgangstransistors gekoppelt ist, sowie eine erste Kompensationskapazität, die mit einem Knoten zwischen dem Emitter des Signalverarbeitungtransistor und der Basis des ersten Ausgangstransistors gekoppelt ist. In einer weiteren bevorzugten Ausführungsform umfasst die zweite Signalverarbeitungsstufe mindestens einen zweiten Emitterfolger, dessen Basis mit dem Emitter des Eingangstransistors gekoppelt ist und dessen Emitter mit der Basis des zweiten Ausgangstransistors gekoppelt ist. Zahlreiche weitere Gestaltungen der Signalteilerstufen und Signalverarbeitungsstufen werden für Fachleute naheliegend sein und kommen im Rahmen der Erfindung in Betracht.

Bei einer Ausführungsform mit Kreuzkopplung der Koppelpfade kann das Koppelnetzwerk derart vorgesehen sein, dass die Koppelpfade die Basis des ersten Ausgangstransistors der einen Schaltungshälfte mit der Basis des zweiten Ausgangstransistors der anderen Schaltungshälfte verbinden. Falls die oberen Pfade einen Emitterfolger, wie zuvor beschrieben, enthalten, können die Koppelpfade alternativ auch die Basis des Emitterfolgers des ersten Pfades der einen Schaltungshälfte mit der Basis des zweiten Ausgangstransistors der anderen Schaltungshälfte verbinden.

In einer weiteren Ausführungsform verbinden die Koppelpfade in jeder Schaltungshälfte jeweils die Basis des ersten Ausgangstransistors mit der Basis des zweiten Ausgangstransistors.

In einer bevorzugten Ausführungsform ist in jeden der Koppelpfade eine zweite Kompensationskapazität geschaltet. Diese kompensiert jeweils teilweise oder vollständig den Umladestrom, der in die Basis-Kollektor-Kapazität des unteren Ausgangstransistors fließt, wenn sich die Spannung am Ausgangsknoten ändert.

Bei einer Ausführungsform mit vertikaler Kopplung der Koppelpfade in jeder Schaltungshälfte kann der Koppelpfad jeweils die Basis des ersten Ausgangstransistors mit der Basis des zweiten Ausgangstransistors verbinden. Falls die oberen Pfade einen Emitterfolger, wie zuvor beschrieben, enthalten, können die Koppelpfade alternativ auch in jeder Schaltungshälfte jeweils die Basis des Emitterfolgers des ersten Signalpfades mit der Basis des zweiten Ausgangstransistors verbinden.

Die Signalteilerstufen umfassen in einer Ausführungsform der erfindungsgemäßen Schaltung einen Eingangstransistor, dessen Kollektor mit dem ersten Signalpfad gekoppelt ist und dessen Emitter mit dem zweiten Signalpfad gekoppelt ist, sowie einen Lastwiderstand an dem Kollektor.

In einer weiteren bevorzugten Ausführungsform können die Signalteilerstufen ferner jeweils eine weitere Kompensationskapazität enthalten, die zwischen den Eingang der einen Schaltungshälfte und den Kollektor des Eingangstransistors der anderen Schaltungshälfte geschaltet ist, wobei diese weitere Kompensationskapazität und die erste Kompensationskapazität dann relativ zueinander derart dimensioniert sind, dass sie das Frequenzverhalten und die Anstiegszeiten der Knoten im oberen Signalpfad optimieren. Ferner können die Signalteilerstufen jeweils einen Rückkopplungswiderstand enthalten, der zwischen den Signaleingang und den Kollektor des Eingangstransistors geschaltet ist. Durch diese Frequenzkompensationsmaßnahmen wird der Frequenzgang im oberen Pfad kompensiert, wodurch eine Zeitverzögerung des oberen Pfades nicht mehr notwendig ist und die Schaltung schneller wird.

Erfindungsgemäß wird außerdem ein integriertes Schaltungsbauelement zur Verfügung gestellt, das auf der vorstehend beschriebenen Durchbruchsspannungsverdopplerschaltung basiert. Ein mit der erfindungsgemäßen Schaltungstopologie hergestellter 40 Gbit/s-Modulatortreiber verbraucht bei einem differentiellen Ausgangshub von 6 Vpp nur 1,3 W, was nur zirka 30 % der Leistungsaufnahme vergleichbarer, in Silizium realisierter Treiber ist.

Weitere Merkmale und Vorteile der Erfindung werden anhand der detaillierten Beschreibung deutlich werden, in der Ausführungsbeispiele näher erläutert werden und die anhand der beigefügten Zeichnungen gegeben wird. Dabei zeigt:

| | |
|---|---|
| Fig. 1 | eine bekannte Durchbruchsspannungsverdopplerstufe; |
| Fig. 2 | eine weitere bekannte Durchbruchsspannungsverdopplerstufe; |
| Fig. 3 | ein Prinzipschema einer Durchbruchsspannungsverdopplerschaltung gemäß der Erfindung; |
| Fig. 4 | stellt eine negative "Miller-Kapazität" in einem differentiellen Paar dar; |
| Fig. 5 | zeigt das Kleinsignal-Äquivalent der linken Hälfte der Schaltung aus Fig. 3; |
| Fig. 6 | stellt eine äquivalente Umformung der Schaltung aus Fig. 5 für Rechenzwecke dar; |
| Fig. 7 | zeigt einen Pol-Nullstellenplan in der komplexen Ebene für unterschiedliche Werte von $R_E$; |
| Fig. 8 | zeigt die Bandbreite der Stufe aus Fig. 6 für unterschiedliche Werte von $R_E$; |
| Fig. 9 | stellt eine bevorzugte Ausführungsform der Schaltung gemäß der Erfindung dar; |
| Fig. 10 | zeigt die Eingangskapazität in Richtung der Basis von $T_{11}$ betrachtet; |
| Fig. 11 | zeigt die Signalamplitude am Knoten X für unterschiedliche Kombinationen von Werten der Kompensationskapazitäten $C_H$ und $C_{M2}$; die |
| Fign. 12 (a) und (b) | zeigen ein Schema der Spannungspegel und zugehörigen Ströme am oberen und unteren Ausgangstransistor; |
| Fig. 13 | stellt die Ausgangsspannung bei 40 Gbit/s für unterschiedliche Werte von $C_H$ dar; |
| Fig. 14 | zeigt eine zweistufige Vorstufe zum Zwecke der Eingangsanpassung; |
| Fig. 15 | zeigt ein Foto eines gemäß der Erfindung realisierten Modulatortreiber-Chips; |
| Fig. 16 | stellt gemessene differentielle Kleinsignalparameter dar; und |
| Fig. 17 | stellt ein Augendiagramm von Großsignalmessungen des erfindungsgemäßen Treiberchips dar. |

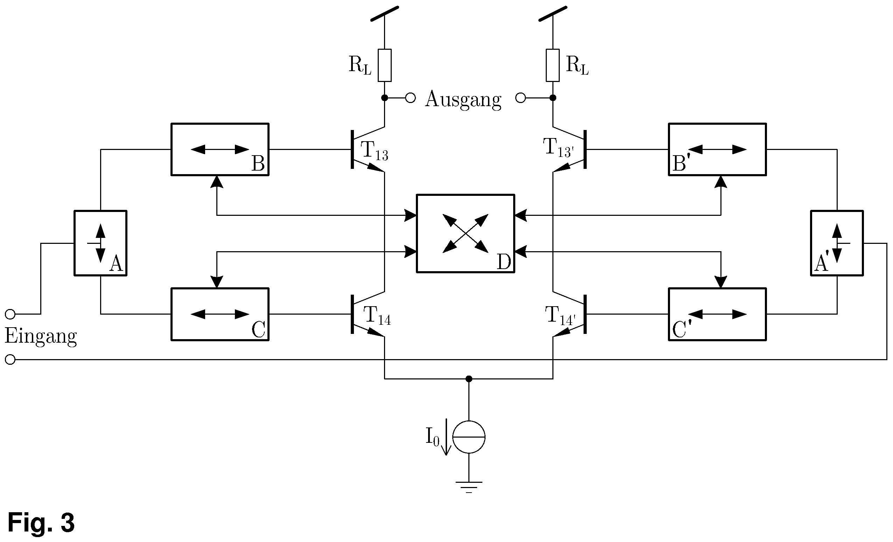

Fig. 3 zeigt einen prinzipiellen Schaltungsaufbau einer Durchbruchsspannungsverdopplerschaltung gemäß der Erfindung. Die Schaltung umfasst zwei symmetrische Schaltungshälften, deren einander entsprechende Bestandteile in der Figur mit denselben Bezugszeichen und zur Unterscheidung in der zweiten Schaltungshälfte zusätzlich mit Apostroph bezeichnet sind. Jede Schaltungshälfte umfasst dabei eine Ausgangsstufe mit jeweils einem ersten, $T_{13}$, $T_{13'}$, und einem zweiten, $T_{14}$, $T_{14'}$, Ausgangstransistor in einer gestapelten Konfiguration. Mit 'gestapelt' ist hierbei gemeint, dass der Emitter des ersten Ausgangstransistors mit dem Kollektor des zweiten Ausgangstransistors verbunden ist. Außerdem umfasst jede Schaltungshälfte eine Signalteilerstufe, A, A', die mit dem Eingang gekoppelt ist und die über einen ersten Signalpfad mit dem ersten Ausgangstransistor und über einen zweiten Signalpfad mit dem zweiten Ausgangstransistor gekoppelt ist. Ferner umfasst jede Schaltungshälfte eine erste Signalverarbeitungsstufe, B, B', in dem ersten Signalpfad und eine zweite Signalverarbeitungsstufe, C, C', in dem zweiten Signalpfad; wobei das Schaltungsbauelement dafür ausgelegt ist, eine Ausgangsspannung gleichmäßig auf die beiden gestapelten Ausgangstransistoren $T_{13}$, $T_{13'}$ bzw. $T_{14}$, $T_{14'}$ zu verteilen, um eine Spannung bereitzustellen, welche die Durchbruchsspannung jedes einzelnen der Ausgangstransistoren $T_{13}$, $T_{14}$, $T_{13'}$, $T_{14'}$ übersteigt.

Wie bis hierher beschrieben, kann die Schaltung aus Fig. 3 entsprechend der von Mandegaran vorgeschlagenen Schaltung ausgebildet sein, die in Fig. 2 gezeigt ist. In diesem Falle würde die Schaltung also in der Signalteilerstufe mindestens einen Eingangstransistor $T_{10}$ bzw. $T_{10'}$ umfassen, dessen Kollektor mit dem ersten Signalpfad gekoppelt ist und dessen Emitter mit dem zweiten Signalpfad gekoppelt ist. Außerdem würden die Signalteilerstufen A, A' jeweils einen Lastwiderstand $R_{L2}$ an dem Kollektor umfassen. Außerdem enthalten bei einer solchen Ausführungsform die ersten Signalverarbeitungsstufen B und B' jeweils mindestens einen ersten Emitterfolger $T_{11}$, bzw. $T_{11'}$. Die Basis von $T_{11}$, bzw. $T_{11'}$ ist mit dem Kollektor des Eingangstransistors $T_{10}$ bzw. $T_{10'}$ gekoppelt und der Emitter von $T_{11}$, bzw. $T_{11'}$ ist mit der Basis des ersten Ausgangstransistors $T_{13}$ bzw. $T_{13'}$ gekoppelt. Weiterhin ist der ersten Signalverarbeitungsstufe B bzw. B' eine Kompensationskapazität $C_H$ zuzurechnen die mit einem Knoten zwischen dem Emitter des ersten Emitterfolgers $T_{11}$, bzw. $T_{11'}$ und der Basis des ersten Ausgangstransistors $T_{13}$ bzw. $T_{13'}$ gekoppelt ist. Außerdem enthalten in diesem Fall die zweiten Signalverarbeitungsstufen C bzw. C' jeweils mindestens einen zweiten Emitterfolger $T_{12}$ bzw. $T_{12'}$, dessen Basis mit dem Emitter des Eingangstransistors gekoppelt ist und dessen Emitter mit der Basis des zweiten Ausgangstransistors $T_{14}$ bzw. $T_{14'}$ gekoppelt ist.

Im Unterschied zu der Schaltung von Mandegaran sind nun aber in der erfindungsgemäßen Schaltung die Signalpfade der beiden Schaltungshälften über ein Koppelnetzwerk D kreuzgekoppelt, d.h. der obere Signalpfad der ersten Schaltungshälfte ist mit dem unteren Signalpfad der zweiten Schaltungshälfte gekoppelt und der untere Signalpfad der ersten Schaltungshälfte ist mit dem oberen Signalpfad der zweiten Schaltungshälfte gekoppelt. Das Koppelnetzwerk kann in der einfachsten Ausführungsform sich überkreuzende Leitungen enthalten.

Wenngleich bereits mit der vorgeschlagenen Kreuzkopplung gemäß Fig. 3 die Nachteile der bekannten Schaltungen hinsichtlich Geschwindigkeit überwunden werden, kann das Verhältnis von Geschwindigkeit zu Leistungsaufnahme der Schaltung, das allgemein als Bewertungskriterium dient, mit verschiedenen zusätzlichen Frequenzkompensationsmaßnahmen weiter verbessert werden, die erfindungsgemäß vorgeschlagen werden. Diese Frequenzkompensationsmaßnahmen, die nachstehend im Detail erörtert werden, können zusätzlich zu der Kreuzkopplung der Signalpfade getrennt voneinander oder in Kombination realisiert werden.

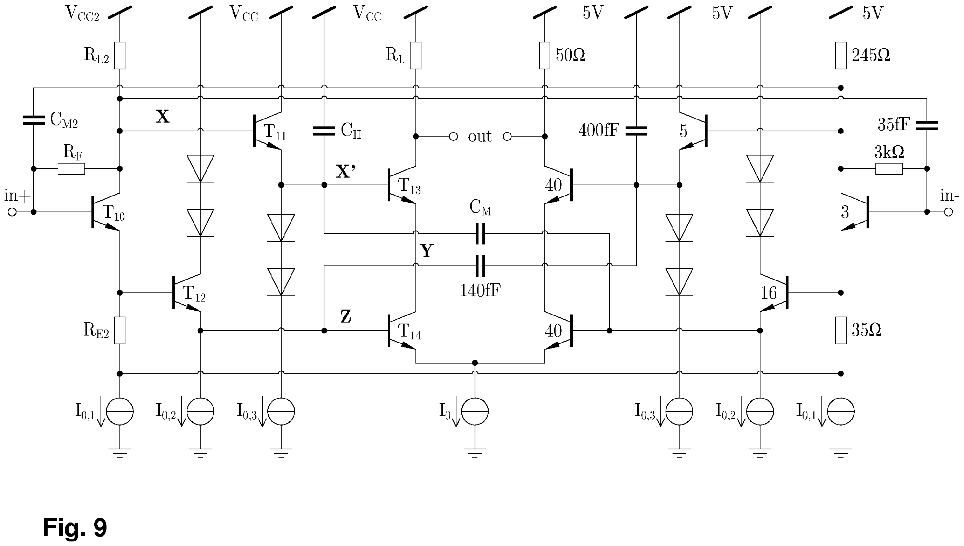

In einer bevorzugten Ausführungsform enthält das Koppelnetzwerk D aus Fig. 3 in jedem Koppelpfad eine Kompensationskapazität, die in Fig. 9 mit $C_M$ bezeichnet ist. Diese lässt sich als so genannte "negative Miller-Kapazität" beschreiben. Zum besseren Verständnis sollen hier zunächst grundsätzliche Überlegungen dazu erörtert werden.

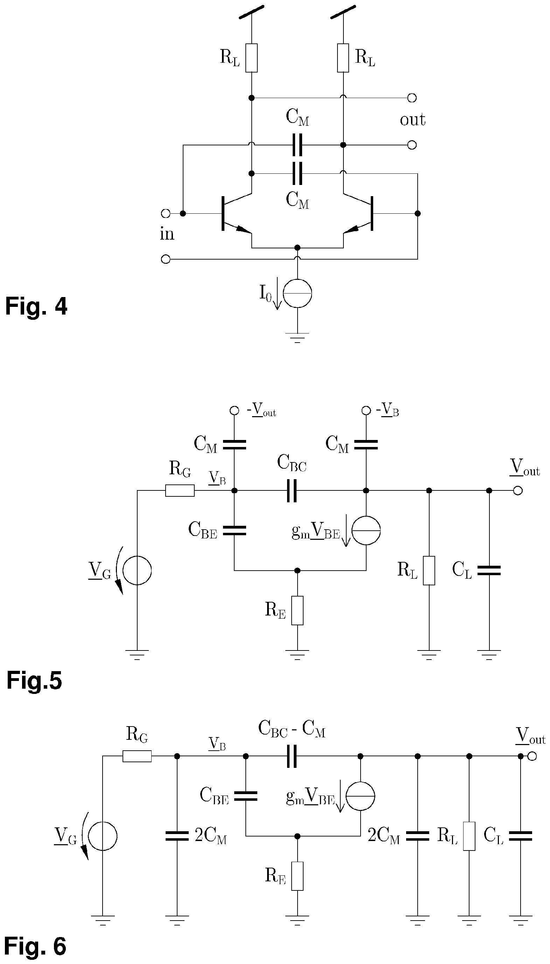

Eine "negative Miller-Kapazität" (NMC), auch als "Neutralisation" bezeichnet, stellt eine Möglichkeit zur Neutralisierung des Einflusses einer Kollektor-Basis-Kapazität dar, um die Bandbreite und die Richtwirkung der Schaltung zu verbessern. Man vergleiche z.B. Tietze, U., Schenk, C.: "Halbleiter-Schaltungstechnik", Springer, 2002. Die zugrunde liegende Idee besteht darin, den Strom, der in die Basis-Kollektor-Kapazität eines Transistors fließt, mit einer parallelen, "negativen" Kapazität zu kompensieren. Sämtliche Einflüsse der unerwünschten Rückkopplung über die Basis-Kollektor-Kapazität, beispielsweise die Bandbreitenbeschränkungen aufgrund des Miller-Effekts, sollten damit - theoretisch - behoben werden. Die negative Kapazität wird approximiert durch eine positive Kapazität, die an einen Punkt mit entgegengesetzter Phase geschaltet wird, d. h. an den Kollektor des entgegengesetzten Transistors in einem differentiellen Paar, wie in Fig. 4 gezeigt. Das Kleinsignal-Äquivalent der linken Hälfte der differentiellen Stufe aus Fig. 4 ist in Fig. 5 gezeigt. Sie enthält zwei separate Kapazitäten $C_M$, welche den Einfluss der NMC auf den Basis- bzw. den Emitterknoten modellieren, die in eine Basis-Kollektor-, Basis-Emitter- und Lastkapazität aufgenommen werden können, wie in Fig. 6 gezeigt ist. Der Emitter-Widerstand $R_E$ stellt die Summe aller parasitären Emitter-Pfad-Widerstände und eines etwaigen, zusätzlich eingefügten seriellen Rückkopplungswiderstandes dar. Fig. 6 veranschaulicht, weshalb, wenn $C_M$ gleich $C_{BC}$ gesetzt wird, die Basis-Kollektor-Kapazität $C_{BC}$ effektiv neutralisiert wird, aber nicht die maximale Bandbreite am Ausgang bereitgestellt werden kann, da sich $C_M$ doppelt zu der Basis-Emitter-Kapazität addiert, wodurch die Bandbreite am Eingangsknoten vermindert wird. Die Erfinder haben, wie nachstehend dargestellt, zunächst die Effizienz einer solchen Kompensationskapazität allgemein berechnet und wesentliche Einflüsse analysiert.

Vernachlässigt man zunächst den Emitter-Widerstand $R_E$, den Basis-Emitter-Widerstand $r_{BE}$ und die Lastkapazität $C_L$, so lautet der Ausdruck für die Kleinsignal-Ausgangsspannung:

$$\frac{\underline{V}_{out}(s)}{\underline{V}_G} = -v_0 \frac{1 + a_1 \cdot s}{1 + b_1 \cdot s + b_2 \cdot s^2} \qquad (6),$$

mit

$$v_0 = g_m R_L,$$

$$a_1 = \frac{C_M - C_{BC}}{g_m},$$

$$b_1 = (C_M + C_{BC})(R_L + R_G) + g_m R_L R_G (C_{BC} - C_M) + C_{BE}$$

$$b_2 = (C_M C_{BE} + C_{BC} C_{BE} + 4 C_M C_{BC}) R_L R_G \qquad (7).$$

Die Nullstelle der Übertragungsfunktion liegt bei Frequenzen weit jenseits der Betriebsfrequenzen der Schaltung und kann daher vernachlässigt werden. Für $C_M = 0$ ist das Polpaar reell, mit einem dominierenden Pol am Basis-Knoten. Die beiden Pole nähern sich bei steigender $C_M$ an und werden schließlich komplex konjugiert und danach wieder reell, wie in Fig. 6 gezeigt ist. Insbesondere zeigt Fig. 6 einen Pol-Nullstellenplan in der komplexen Ebene für unterschiedliche Werte von $R_E$ basierend auf praktischen (Dimensionierungs-) Werten der Elemente in der Treiberstufe. Der Beginn der jeweiligen Spur bei $C_M=0$ ist zur Verdeutlichung durch das jeweilige Symbol (gefüllte(r/s) Kreis, Quadrat, Dreieck) markiert. Der Punkt, an dem die Lage des Frequenzgangs die imaginäre X-Achse schneidet, stellt den oberen Grenzwert für $C_M$ dar, da die Schaltung jenseits dieses Punktes instabil wird. Den entsprechenden Wert für $C_M$ erhält man, indem $b_1 = 0$ gesetzt wird, als

$$C_{M,max} = \frac{C_{BC} R_L + \left[ (v_0 + 1) C_{BC} + C_{BE} \right] R_G}{v_0 R_G - R_L}. \qquad (8).$$

In Gleichung (8) ist angenommen, dass die Pole an diesem Punkt komplex sind, was für $R_E = 0$ der Fall ist. Der Einfluss von $R_E$ wird später noch diskutiert.

Die Bandbreite der Schaltung kann in diesem Fall nicht direkt aus der Lage der Pole abgelesen werden, da die Pole nahe der imaginären Achse liegen und ein Überschwingen des Frequenzgangs bewirken. Da die Lage der Pole die Resonanzfrequenz anzeigt, ist die Bandbreite bei 3 dB tatsächlich höher, und zwar aufgrund des Überschwingens der Frequenzantwort Flankensteilheit bei hoher Frequenz. Die Bandbreite und das Überschwingen der Frequenz erhöhen sich zu $C_{M.max}$ hin. Das Überschwingen der Frequenz ist jedoch bei Breitbandanwendungen unerwünscht. Üblicherweise wird für solche Schaltungen eine Butterworth-Pol-Position gewählt, da die Schaltung einen flachen Frequenzgang und eine ausreichende Spanne zur Instabilität, bei gleichzeitig höherer Bandbreite aufweist. Die entsprechenden Werte für $C_M$ erhält man durch Lösen von

$$\left| b_1 \right| = \sqrt{b_1^2 - 4 b_2} \qquad (9)$$

für $C_M$. Von praktischer Bedeutung ist nur die Lösung von (9) für die linke Ebene. Mit geeigneten Näherungen basierend auf $v_0 \square 1$ kann der Optimalwert für NMC gemäß (10) bestimmt werden:

$$C_{M,Butterworth} \cong \frac{g_m R_G^2 (v_0 C_{BC} + C_{BE}) - \sqrt{8 g_m R_G^3 \left( v_0 C_{BC}^2 + \frac{v_0}{2} C_{BC} C_{BE} + \frac{1}{4} C_{BE}^2 \right)}}{R_L (g_m R_G - 1)^2} \qquad (10).$$

Durch den Emitterwiderstand $R_E$ wird eine Stromrückkopplung in die Schaltung eingeführt, was auf Kosten der Verstärkung und zugunsten der Bandbreite geht. $R_E$ ist in jeder praktischen Schaltung vorhanden, da Transistoren einen parasitären Widerstand im Emitterpfad besitzen, und dieser kann gezielt verstärkt werden, indem ein externer Widerstand hinzugefügt wird. Durch die Stromrückkopplung kommen in Gleichung (6) eine zweite Nullstelle und ein dritter Pol hinzu, für praktische Werte von Bauteilen liegen diese jedoch außerhalb des interessierenden Frequenzbereichs und können daher vernachlässigt werden. Der Pfad der Polstellen in der komplexen Ebene ist daher ähnlich demjenigen mit $R_E = 0$, wie in Fig. 6 gezeigt. Er ist jedoch nach links verschoben, da $R_E$ die Bandbreite der Schaltung vergrößert. Darüber hinaus verschiebt sich durch $R_E$ der Kreuzungspunkt mit der imaginären Achse und somit der Wert für $C_{M,max}$ zu höheren Werten von $C_M$. Der entsprechende Ausdruck wird mithilfe desselben Algorithmus wie oben beschrieben erhalten und kann angenähert werden als

$$C_{M,max}' \cong \frac{\left(v_0 C_{BC} + C_{BE}\right) R_G + \left(1 + g_m R_E\right) C_{BC} R_L + C_{BE} R_E}{g_m R_G \left(R_L - R_E\right) - \left(1 + g_m R_E\right) R_L} \qquad (11).$$

Diese Gleichung gilt für Werte von $R_E$, mit

$$R_E < \frac{R_L \left(g_m R_G - 1\right)}{g_m \left(R_G + R_L\right)} \qquad (12),$$

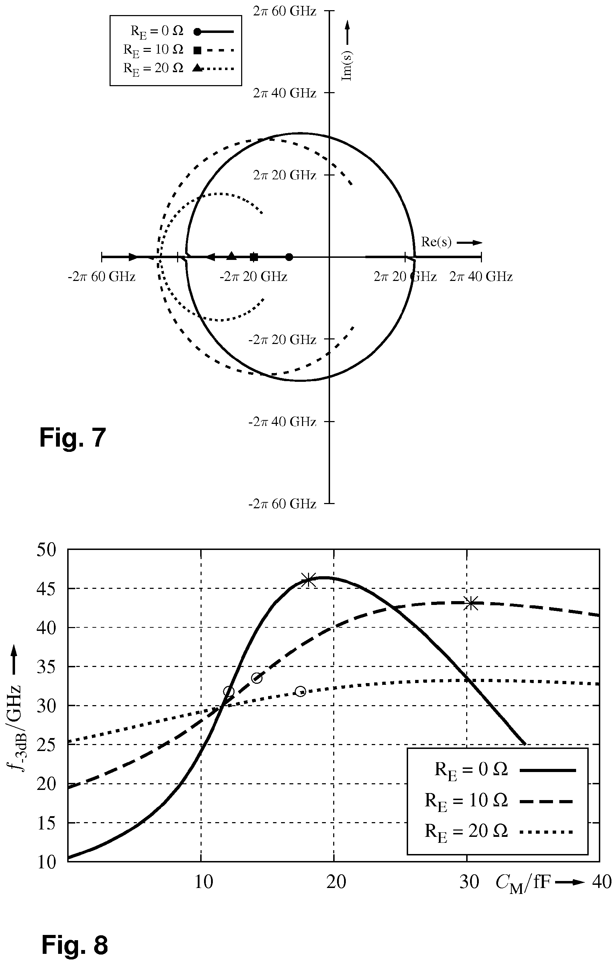

da in (11) angenommen wird, dass die entsprechenden Pole rein imaginär sind. Für höhere Werte von $R_E$ liegt der Bereich der komplexen Pole weit entfernt von der imaginären Achse. Die Stabilität spielt dann für die Abwägung des Designers hinsichtlich $C_M$ keine Rolle mehr, da die Bandbreite der Schaltung tatsächlich mit steigenden $C_M$ abfällt.
Die Erhöhung der Bandbreite, die mit der NMC in der Treiberstufe erreicht wird, ist in Fig. 8 dargestellt. Insbesondere zeigt Fig. 8 die Bandbreite der Stufe aus Fig. 4 für unterschiedliche Werte von $R_E$. Die Kapazitätswerte für das Butterworth-Verhalten und die Instabilität sind mit Kreisen beziehungsweise Kreuzen markiert. Es ist offensichtlich, dass die NMC für höhere Werte von $R_E$ weniger effektiv ist. Die maximale Erhöhungsrate der Bandbreite für praktische Werte von $R_E$ entsprechend dem parasitären Pfadwiderstand beträgt ungefähr 2.
In der Kleinsignalanalyse der grundlegenden BVD-Topologie bei Mandegaran wird die Rückkopplung zwischen oberem und unterem Pfad vernachlässigt und die Ausgangsspannung wird als Überlagerung der jeweiligen Kleinsignalspannungen berechnet. Es wird dann gezeigt, dass durch Anpassung der Kompensationskapazität $C_H$ die Nullstellen in der Übertragungsfunktion verschoben werden können, um die Bandbreite zu maximieren.
Bei der erfindungsgemäß vorgeschlagenen Topologie beeinflusst jedoch der untere Pfad stark den oberen Pfad, da der obere Ausgangstransistor $T_{13}$ die Impedanz, die in Richtung des Kollektors des unteren Ausgangstransistors $T_{14}$ zu sehen ist, als Emitter-Impedanz sieht, wodurch eine starke Rückkopplung entsteht. Der untere Pfad ist jedoch von dem oberen Pfad gut isoliert, da die Rückwirkung des unteren Transistors gering ist und durch die Kreuzkopplung der Signalpfade einschließlich der NMCs verbessert ist. Da eine vollständige Analyse zu komplex ist, um sinnvolle analytische Ergebnisse zu erhalten, besteht der genaueste Ansatz darin, die Engpässe hinsichtlich der Geschwindigkeit in dem oben und dem unteren Pfad getrennt zu analysieren und zu optimieren.
Im unteren Pfad befindet sich der Geschwindigkeitsengpass am Basisknoten des Ausgangstransistors $T_{14}$ und ist in Fig. 9 mit Z bezeichnet.
Die Fig. 9 zeigt ein derzeit bevorzugtes Implementierungsbeispiel der erfindungsgemäßen Durchbruchsspannungsverdopplerschaltung. Auf der linken Seite sind die Schaltungselemente und die im Beschreibungstext verwendet Knotennamen angegeben, auf der rechten Seite sind beispielhafte Dimensionierungsgrößen für die Elemente angegeben. Die Zahlen an den Transistoren geben dabei die Größe der Transistoren als Relativwerte an. Es versteht sich, dass die Erfindung in keiner Weise auf die hier angegebenen beispielhaften Werte zu beschränken ist. Sämtliche Stromquellen sind einfache bipolare Stromspiegel, die Dioden sind Transistordioden, die lediglich zum Kollektor-Emitter-Durchbruchsschutz genutzt werden. Die Zeitkonstante am Knoten Z besteht aus der Eingangskapazität des Ausgangstransistors, wobei diese groß ist, da der Transistor groß ist, sowie der Ausgangsimpedanz der unteren Kollektorstufe. Diese Impedanz ist direkt mit dem Betriebsstrom von $T_{12}$ verknüpft:

$$R_{out} \approx \frac{1}{g_m} = \frac{U_T}{I_{0,4}} \qquad (13).$$

Daher muss im unteren Pfad beim Entwurf ein Kompromiss zwischen Geschwindigkeit und Leistungsaufnahme für $T_{12}$ gefunden werden. Ein größerer Transistor $T_{14}$ würde eine größere Treiberstufe $T_{12}$ erfordern, was zu einer noch höheren Leistungsaufnahme führt.
Erfindungsgemäß werden negative Miller-Kapazitäten (NMCs), wie sie zuvor erörtert worden sind, als Kompensationskapazitäten $C_M$ in den Koppelpfaden genutzt. Damit gelingt es, die Bandbreite am Knoten Z zu erhöhen und die Leistungsaufnahme der unteren Kollektorstufe $T_{12}$ zu vermindern. Wären die NMCs mit der in Fig. 4 gezeigten Konfiguration geschaltet, würden sie jedoch die am Emitter zu sehende Impedanz beträchtlich beeinflussen, was im vorliegenden Fall nicht vorteilhaft wäre. Daher sind die NMCs in einer bevorzugten Ausführungsform mit der Basis des oberen Ausgangstransistors $T_{13}$ gekoppelt, also mit dem Knoten X', wie in Fig. 9 dargestellt ist. Gleichermaßen ist es möglich, die NMCs mit der Basis des oberen Emitterfolgers $T_{11}$, also dem Knoten X, zu verbinden. Da der Knoten X' und der Knoten Y nur durch die (nahezu konstante) Basis-Emitter-Spannung von $T_{13}$ getrennt sind, haben diese beiden gegenüber der Fig. 4 modifizierten Anschaltungen der NMC den gleichen Einfluss auf den Knoten Z wie zuvor berechnet. Trotz der NMC wird die Geschwindigkeit an der unteren Basis durch die Spannungsanstiegsgeschwindigkeit begrenzt, wie noch gezeigt wird. Daher kompensieren die NMCs die Basis-Kollektor-Kapazität $C_{BC}$ des unteren Transistors nur teilweise, und $T_4$ ist immer noch relativ groß.

Im Gegensatz zur intuitiven Erwartung weist der obere Pfad in der Kleinsignalbetrachtung keine wesentlichen Bandbreiteengpässe auf. Dies ist in der Rückkopplung des unteren Ausgangstransistors $T_{14}$ auf den oberen Transistor $T_{13}$ und die Kollektorstufe begründet. Durch diese Rückkopplung reduziert sich die Eingangskapazität von $T_{11}$ beträchtlich, wie in Fig. 10 gezeigt ist. Fig. 10 zeigt die Eingangskapazität in Richtung der Basis von $T_{11}$ gesehen. Die gestrichelte Linie zeigt die Ergebnisse, die man mit den bei Mandegaran verwendeten Vereinfachungen erhält. Damit wird offensichtlich, warum es für eine exakte Analyse der erfindungsgemäßen Schaltungstopologie unbedingt erforderlich ist, die Rückkopplung zu berücksichtigen.

Dennoch wäre zu erwarten, dass der große Lastwiderstand $R_{L2}$ der Treiberstufe zusammen mit dem Eingang der Kollektorstufe $T_{11}$ am Knoten X einen Tiefpass bildet. Die Eingangsimpedanz von $T_{11}$ wird jedoch durch die Transformation seiner Last, bestehend aus $C_H$ und den gestapelten Ausgangstransistoren, dominiert. Es lässt sich zeigen, dass für eine korrekte Modellierung dieser Eingangsimpedanz ein Transistormodell erforderlich ist, das parasitäre Pfadwiderstände enthält, und dies ist wiederum zu komplex, um analytische Ergebnisse zu erhalten. Es ist zu beachten, dass der Eingangswiderstand in einem Frequenzbereich von ungefähr 1 bis 10 GHz negativ wird. Dies ist ein typisches Phänomen, das an den Eingangskollektorstufen mit kapazitiven Lasten auftritt, das aber nicht notwendiger Weise zu Instabilität führt, da $R_{L2}$ die Knotenimpedanz dominiert und sämtliche umgebenden Knotenimpedanzen wohl definiert sind, siehe Tietze-Schenk.

Durch die Rückkopplung über den unteren Ausgangstransistor wird eine Vorverzerrung bewirkt, wodurch die Kleinsignalbandbreite ausreichend groß wird, aber ein zu hohes Überschwingen der Amplitude im Frequenzbereich auftritt, was zu hohen Gruppenverzögerungsschwankungen und zu Signaljitter führt, wie in Fig. 11 zu erkennen ist. Ein Optimierungsziel besteht deshalb darin, den Frequenzgang im oberen Pfad so flach wie möglich zu gestalten. Dies wird gemäß einer weiteren bevorzugten Ausführungsform der Erfindung durch geeignete Kombination der Kompensationskapazität $C_H$ am Knoten X' mit einer weiteren Kompensationskapazität $C_{M2}$ am Knoten X erreicht, die ebenfalls in Fig. 9 dargestellt ist. Während $C_H$ bei hohen Frequenzen die Verstärkung hauptsächlich verringert, wodurch das Überschwingen des Frequenzgangs vermindert wird, verschieben die NMCs an den Knoten X die Pole wie bereits beschrieben, wodurch sich der Frequenzgang im mittleren Frequenzbereich abflacht. Fig. 11 zeigt die Signalamplitude am Knoten X für unterschiedliche Kombinationen von Werten der Kompensationskapazitäten $C_H$ und $C_{M2}$. Man beachte, dass $C_{M2}$ im Gegensatz zur intuitiven Erwartung die Signalbandbreite nicht wesentlich verändert. Die Erfinder haben erkannt, dass eine Kleinsignalanalyse allein für eine Optimierung der erfindungsgemäßen Durchbruchsspannungsverdopplerschaltung nicht ausreicht. Besonders bemerkenswert ist, dass $C_H$ aus Kleinsignalsicht den Knoten X' und die Schaltung verlangsamt, wogegen die nachstehenden Großsignalbetrachtungen zeigen werden, dass $C_H$ den Knoten X' beschleunigt, wodurch ein Hochgeschwindigkeitsbetrieb überhaupt möglich wird.

In Fig. 9 ist außerdem eine zusätzliche parallele Rückkopplung in der Treiberstufe über einen Parallel-Widerstand $R_F$ dargestellt. Dies stellt eine weitere Optimierungsoption entsprechend der Erfindung dar. Diese Rückkopplung ist jedoch sehr schwach, da der Wert von $R_F$ hoch ist, und sie hat keinen wesentlichen Einfluss auf das Hochfrequenzverhalten der Schaltung. Ihr hauptsächlicher Zweck besteht in der Anpassung der Signalamplitude am Knoten X, um sicherzustellen, dass beide Ausgangstransistoren ($T_{13}$ und $T_{14}$ bzw. $T_{13'}$ und $T_{14'}$) die Ausgangsspannung stets gleichmäßig aufteilen.

Die dominanten geschwindigkeitsbegrenzenden Effekte für die gesamte Schaltung sind die Basis-Ströme der Ausgangstransistoren. Um den Ausgangshub zu maximieren, werden die Transistoren im Zustand "on" so nah wie möglich an die Sättigung gefahren und im Zustand "off" so nah wie möglich an den Durchbruch. Aber selbst wenn die Schaltung gut dimensioniert ist und statische Ströme an der Basis gering gehalten werden, sind hohe Stromspitzen erforderlich, um die parasitären Kapazitäten wieder aufzuladen. Tatsächlich sind diese um mindestens eine Größenordnung höher als der statische Durchbruchsstrom am Kollektor, der bereits beschrieben worden ist, oder der Basisstrom im Normalbetrieb. Die größte Herausforderung beim Entwurf besteht deshalb darin, diese Ströme an der Basis zu beherrschen.

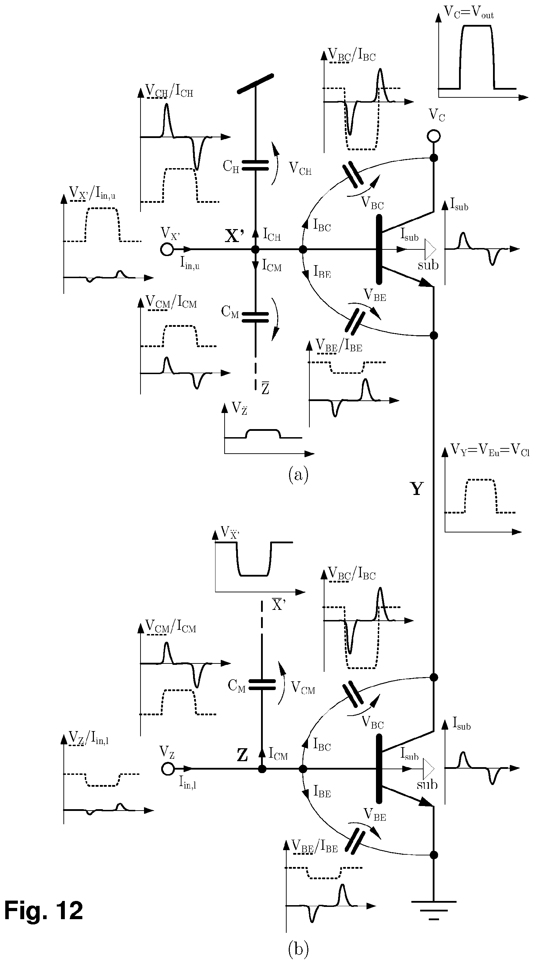

Fig. 12 zeigt ein Schema der Spannungspegel und zugehörigen Ströme am oberen und unteren Ausgangstransistor. Die Buchstaben X', Y, Z an den Knoten entsprechen denen aus den Fig. 2 und 9, der Knoten auf der anderen Seite der differenziellen Struktur ist mit einem Überstrich gekennzeichnet ($\overline{Z}$, $\overline{X}$'). Bezüglich ihrer Emitterpotentiale arbeiten beide Transistoren als Inverter. Wenn also der Transistor an und ausgeschaltet wird, fließen üblicherweise Ströme aus der Basis heraus und in diese hinein, welche die Basis-Emitter- und die Kollektor-Basis-Kapazität umladen. Da die Ausgangstransistoren durch Kollektorstufen angesteuert werden, muss der Strom aus der Basis heraus über die Stromquelle der Kollektorstufe abgeleitet werden. Wenn der Basis-Strom weiter ansteigt, drückt er den Ansteuertransistor in den Inversbetrieb. Dadurch ergibt sich eine Begrenzung der Anstiegsgeschwindigkeit an der Anstiegsflanke des Ausgangs, welche die Geschwindigkeit an den Basisknoten stark begrenzt.

Die erfindungsgemäße Behebung dieses Problems basiert auf den Kompensationskapazitäten $C_H$ und $C_M$. Deren Rolle in der Großsignalbetrachtung wird offensichtlich, wenn man die Spannungs- und Stromkurven in Fig. 12 betrachtet. Schauen wir uns zunächst den unteren Ausgangstransistor in Fig. 12(b) an (entspricht $T_{14}$ in Fig. 9), so weist der Spannungsabfall über die Kapazität $C_M$ immer das zum Spannungsabfall über $C_{BC}$ und $C_{BE}$ entgegengesetzte Vorzeichen auf. Der dynamische Strom $I_{CM}$ hat daher immer das entgegengesetzte Vorzeichen wie $I_{BE}$ und $I_{BC}$, wodurch er diese teilweise kompensiert, so dass der Gesamtstrom $I_{in1}$ in die untere Stufe hinein viel kleiner ist als der Basisstrom des Transistors. Die NMC kann jedoch aus bereits genannten Gründen nicht willkürlich hoch dimensioniert werden, und die durch die Eingangskapazität des Transistors bewirkte Bandbreitenbegrenzung ist beträchtlich, so dass die untere Kollektorstufe vergleichsweise groß sein muss, damit sich ein ausreichend großer Querstrom ergibt, um die Wiederaufladung der Transistorkapazitäten zu gewährleisten.

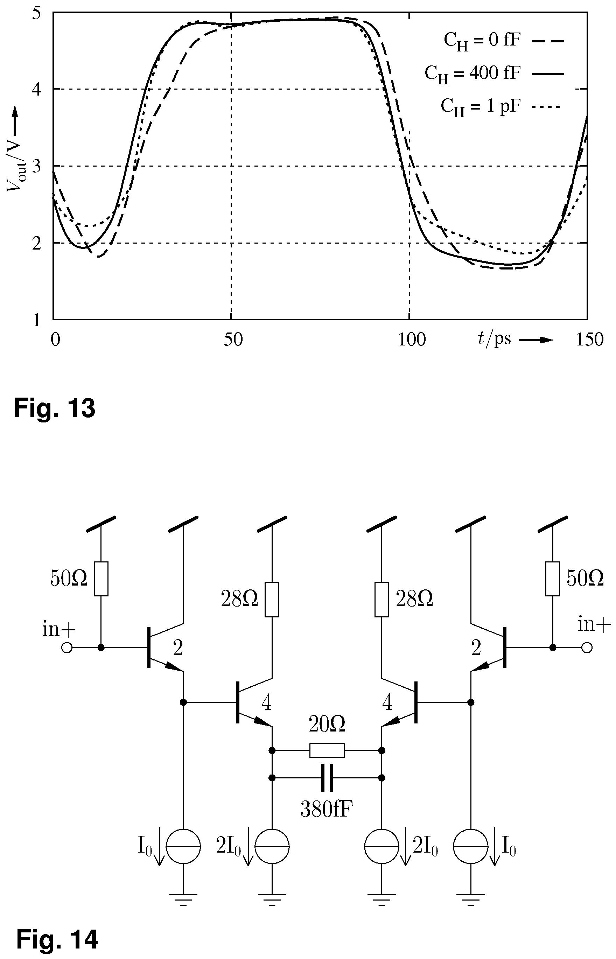

Für den oberen Transistor in Fig. 12(a) (entspricht $T_{13}$ in Fig. 9) ist die Bandbreite am Basisknoten wie bereits beschrieben kein Problem. Während der Transistor selbst, bezogen auf seinen Emitter, außerdem als Inverter arbeitet, bewegt sich das absolute Potential des Basisknotens bezogen auf Masse parallel zum absoluten Kollektorpotential, jedoch mit kleinerer Amplitude. Damit ergeben sich für die parasitären Kapazitäten die gleichen Wiederaufladeströme wie für den unteren Transistor, sie können jedoch durch die Kapazität $C_H$ einfacher kompensiert werden. Wie in Fig. 12(a) gezeigt ist, hat der Strom zu $C_H$, $I_{CH}$, immer die zu $I_{CB}$ entgegengesetzte Richtung. Außerdem hat die NMC am unteren Transistor (aber der anderen Seite in der symmetrischen Struktur) dieselbe Wirkung, wie in den Spannungskurven zu sehen ist. Dies ist gerechtfertigt durch die Tatsache, dass das Basispotential am Knoten Z im Vergleich zu X eine kleine Amplitude aufweist, wodurch es nahezu wie in Kleinsignalbetrachtung mit Masseschluss an $C_H$ wirkt. Grob gesagt wirkt $C_H$, obgleich mit Masse gekoppelt, wie eine negative Kapazität an dem Basis-Knoten des oberen Ausgangstransistors, weil die Spannung am Emitter in Phase mit der Basis ist. Trotzdem bewirkt $C_H$ keine Instabilität, wie die Kleinsignalanalyse offenbart, tatsächlich reduziert sich die Bandbreite am Knoten X'. Je größer $C_H$, desto geringer ist der Gesamteingangsstrom $I_{in,1}$ der oberen Stufe, das heißt desto kleiner kann die obere Kollektorstufe dimensioniert werden. Der obere Grenzwert für $C_H$ wird jedoch durch die Anstiegsgeschwindigkeit begrenzt, da wenn $C_H$ zu groß wird, die Transistorströme zu klein für eine vollständige Wiederaufladung von $C_H$ sind, welche dann über die Treiberstufe erfolgt. Da der Querstrom der Treiberstufe begrenzt ist, vergrößert sich damit in der Großsignalbetrachtung die Anstiegszeit, wie in Fig. 13 gezeigt ist. In Fig. 13 ist eine Ausgangsspannung bei 40 Gbit/s für unterschiedliche Werte von $C_H$ dargestellt.

In einer weiteren Ausgestaltung der erfindungsgemäßen Schaltung wird vor die Ausgangsstufen eine zweistufige Vorstufe gesetzt, und zwar zum Zwecke der Eingangsanpassung und Vorverzerrung des Signals. Ein Implementierungsbeispiel für eine solche Vorstufe ist in Fig. 14 dargestellt. Die Vorstufe besteht aus einer Kollektorstufe und einer Emitterstufe mit Stromrückkopplung. Die Eingangsstufe stellt außerdem den richtigen Spannungshub und die Impedanzpegel am Eingang der Ausgangsstufen ein.

Die Ausgangsanpassung der Schaltung stellt eine Herausforderung dar, da zur Beherrschung der hohen Ströme große Ausgangstransistoren benötigt werden und diese daher große parasitäre Kapazitäten aufweisen. Da das Signal durch diese Kapazitäten zu höheren Frequenzen hin verkürzt wird, vergrößern sich die Ausgangsreflexionskoeffizienten. Dies kann in einem schmalen Frequenzbereich zum Teil durch Stichleitungen kompensiert werden, wie sie gewöhnlich in schmalbandigen Schaltungen genutzt werden. In einem Implementierungsbeispiel der erfindungsgemäßen Schaltung wurde für diesen Zweck eine Übertragungsleitung von 250 $\mu$m Länge mit einer Kapazität von 35 fF am Ende an den Ausgang geschlossen. Die Verbesserung des Ausgangsreflexionskoeffizienten liegt bei 30 bis 40 GHz im Bereich von 1 bis 2 dB.

Zusammenfassend ist zu sagen, dass für die Optimierung der Geschwindigkeit der vorgeschlagenen Schaltung sowohl das Kleinsignalverhalten als auch das Großsignalverhalten berücksichtigt werden muss. Die vorstehend ausführlich diskutierten Frequenzkompensationsmaßnahmen können zusätzlich zu der Kreuzkopplung der Signalpfade getrennt oder in Kombination miteinander realisiert werden. Die NMCs am unteren Ausgangstransistor vergrößern die Bandbreite und wirken Begrenzungen der Anstiegsgeschwindigkeit am Knoten Z entgegen. Die Kompensationskapazität $C_H$ verlangsamt den oberen Pfad und wirkt Begrenzungen der Anstiegsrate entgegen, das heißt sie beschleunigt gleichzeitig den Knoten X'. Der optimale Wert für $C_H$ kann nur durch eine kombinierte Analyse der Kleinsignal- und Großsignalbetrachtung wie vorstehend beschrieben gefunden werden. Schließlich sorgen die NMCs zusammen mit der Parallel-Rückkopplung $R_F$ in der Treiberstufe für eine Feinabstimmung der Verstärkung und des Frequenzgangs der Treiberstufe.

Mit der in Fig. 9 dargestellten bevorzugten Ausführungsform der erfindungsgemäßen Durchbruchsspannungsverdopplerschaltung wurde durch eine Kombination dieser drei Maßnahmen ein optimales Hochfrequenzverhalten der Schaltung sichergestellt und eine Übertragungsrate ermöglicht, die im Vergleich zu der von Mandegaran bekannten Schaltungstopologie um einen Faktor 4 höher ist. während sich die maximale Transitfrequenz der genutzten Technologie nur um 1,5 erhöht hat.

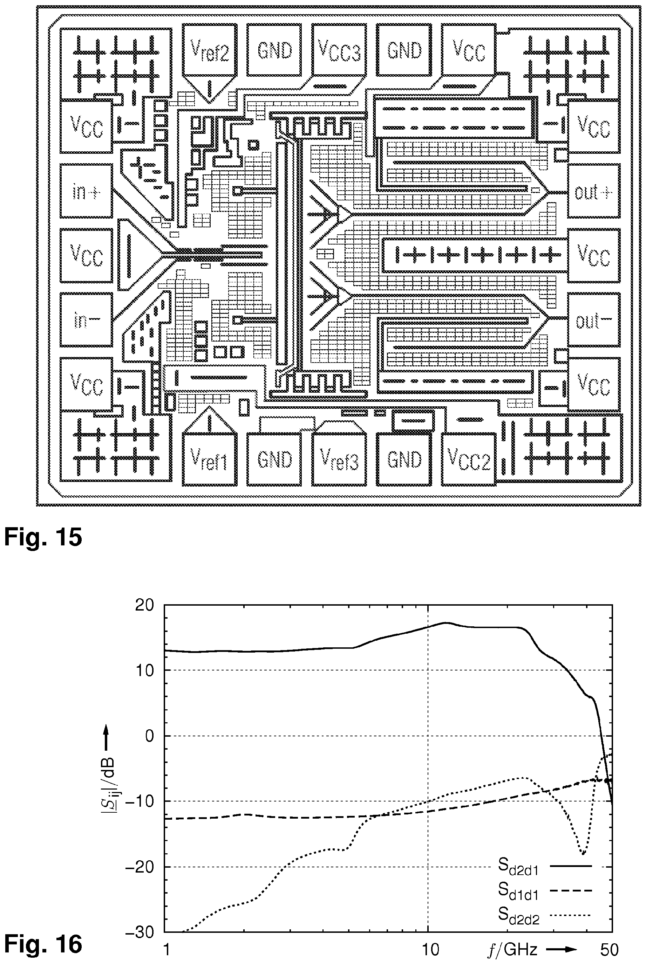

In einem Implementierungsbeispiel wurde die Schaltung in IHP SG25HI SiGe BiCMOS Technologie mit $f_{T,max}$ von 180 GHz gefertigt. Fig. 15 zeigt eine Abbildung eines Chips mit der realisierten Schaltung. Die Abmessungen des Chips betragen lediglich 0,9 mm x 0,8 mm, einschließlich sämtlicher Pads. Der Chip weist drei Versorgungsspannungen und drei Referenzspannungen auf. Vcc und $V_{CC2}$ sind an die Ausgangsspannungsversorgung angeschlossen, wie in Fig. 8 gezeigt, mit Werten von 5,5 V. $V_{CC3}$ stellt die Versorgungsspannung der Eingangsstufe dar, die auf 4 V eingestellt ist.

Die Spannungen wurden auf dem Chip getrennt, um die Möglichkeiten zur Fehlerbehebung zu verbessern, $V_{CC3}$ kann jedoch auch in einfacher Weise auf dem Chip von Vcc abgeleitet werden und der Chip kann durch eine einzige Versorgungsspannung gespeist werden. Das Gleiche gilt für die Referenzspannungen, welche die Stromquellen steuern und lediglich zur manuellen Kompensation von Herstellungstoleranzen bestimmt sind.

Kleinsignalmessungen mit einem 4-Port Netzwerk-Analysator ZVA67 von Rhode&Schwartz ergaben eine differenzielle Verstärkung von 14 dB und eine Bandbreite von 33,7 GHz, wie in Fig. 16 gezeigt ist. Die Reflexionskoeffizienten am Eingang und Ausgang lagen bis zu 10 GHz unterhalb -10 dB und bis zu 40 GHz unterhalb -7 dB. Versehentlich wurden sämtliche Übertragungsleitungen auf dem Chip vor der Herstellung mit metallischen Füllpolygonen gefüllt. Die Funktionalität der Schaltung wurde dadurch nicht beeinträchtigt, jedoch erhöhten sich die Resonanzfrequenzen der Ausgangsanpassungskorrektur leicht, so dass das Maximum der Ausgangsreflexion bei -6,7 dB etwas größer als beabsichtigt war. Dies kann jedoch durch ein überarbeitetes Layout der Übertragungsleitungen beseitigt werden.

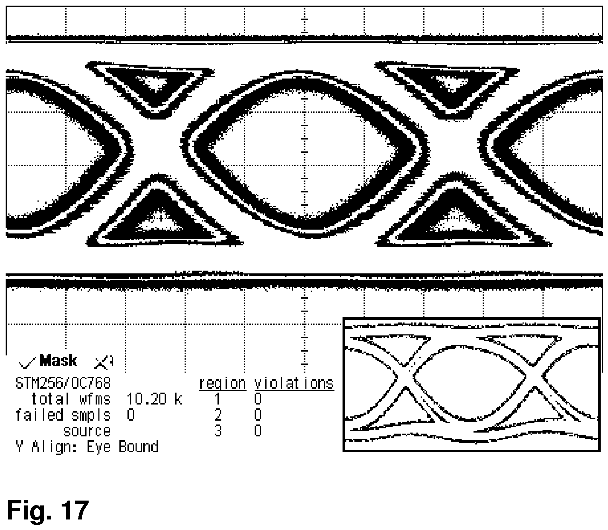

Großsignalmessungen mit einem 40 Gbit/s Bitpatterngenerator zeigten offene Augen bei 40 Gbit/s mit einem Spannungshub von 3 V an einer 50Ω Last, wie in Fig. 17 zu sehen ist. Der ungenutzte zweite Ausgang wurde mit einem Widerstand von 50 Ω abgeschlossen, was bedeutet, dass der Chip einen maximalen Ausgangshub von 6 Vpp differentiell liefern könnte. Die Eingangsspannung für diese Messung bestand in einer $2^{31}$-1 PRBS-Sequenz mit einem differentiellen Hub von 600 mV. Die Versorgungsspannungen betrugen Vcc = $V_{CC2}$ = 5,5 V und $V_{CC3}$ = 3,9 V, die gesamte Gleichspannungs-Leistungsaufnahme ausschließlich der Lasten betrugt 1,35 W. Ein Augenmaskentest mit der Augenmaske OC768/STM256 bei 40 Gbit/s zeigte über 10.000 Wellenformen hin, d.h. innerhalb von 30 Minuten, keine Pixeltreffer in der Maske. Diese Ergebnisse zeigen, dass sich die Schaltung sehr gut für optische Übertragungssysteme mit 40 Gbit/s eignet.

In Tabelle 1 ist die erfindungsgemäße (Durchbruchsspannungsvervielfacher-) Schaltung mit aus dem Stand der Technik bekannten, in Silizium ausgeführten schnellen Treibern mit hohem Spannungshub verglichen. Der Treiber gemäß der Erfindung weist von sämtlichen angegebenen Treibern die größte Bandbreite auf. Die Leistungsaufnahme der erfindungsgemäßen Schaltung liegt bei ungefähr 30% derjenigen des vergleichbaren 40 Gbit/s-Treibers unter [5] und des 10 Gbit/s-Treibers unter [2]. Damit ist klar der Vorteil der modifizierten Topologie des Durchbruchsspannungsverdopplers der vorliegenden Erfindung gegenüber alternativen Ansätzen aufgezeigt.

Vorliegend wurde somit eine modifizierte Topologie eines Durchbruchsspannungsvervielfältigers für Breitbandverstärker aufgezeigt, die einen hohen Ausgangsspannungshub mit hohen Geschwindigkeiten ermöglicht und gleichzeitig die Leistungsaufnahme vermindert. Die Analyse hat gezeigt, dass die hauptsächlich die Geschwindigkeit beschränkenden Knoten die Basen der Ausgangstransistoren sind. Die Kleinsignalbandbreite stellt nur im unteren Signalpfad ein Problem dar und kann mithilfe von negativen Miller-Kapazitäten (NMC) effektiv verbessert werden. Im oberen Pfad ist die Bandbreite aufgrund der Emitter-Rückkopplung auf den unteren Ausgangstransistor an sich bereits hoch, aber eine durch die hohen Basisströme der Ausgangstransistoren verursachte Anstiegsrate bewirkt Geschwindigkeitsbegrenzungen. Die Kapazität $C_H$ und die negative Miller-Kapazität $C_{M2}$ in der Treiberstufe werden genutzt, um das Frequenzverhalten und die Anstiegszeiten der Knoten im oberen Pfad zu optimieren. Mit einer Kombination der vorliegend beschriebenen Frequenzkompensationsmaßnahmen wurde mit der erfindungsgemäßen Schaltung ein 40 Gbit/s-Modulatortreiber in 180 GHz SiGe BiCMOS Technologie realisiert. Der Treiber weist eine Kleinsignalverstärkung von 14 dB und eine gute Eingangs- und Ausgangsanpassung auf. Er zeigt offenen Ausgangsaugen bei 40 Gbit/s und liefert einen Ausgangshub an einem Ende von 3 Vpp zu einer 50 Ω-Last (6 Vpp differentiell) bei einer Leistungsaufnahme von nur 1,3 W. Nach Kenntnis der Erfinder realisiert die Schaltung entsprechend der Erfindung den derzeit schnellsten und energieeffizientesten aller in Silizium ausgeführten Treiber mit hohem Spannungshub.

Tabelle 1: Vergleich von in SiGe-Technologie ausgeführten Laser-/Modulatortreibern mit hohem Spannungshub

| Referenz | Übertragungs-geschwindig-keit [Gbit/s] | KleinsignalBandbreite [GHz] | differentielle Verstärkung [dB] | Versorgungsspannung [V] | Ausgangshub [V] | Gleichstrom-Leistung [mW] | Technologie | Typ |
|---|---|---|---|---|---|---|---|---|
| [1] | 10 | keine Angabe | keine Angabe | 5 | 4,5 | 1000 | 0,35μm BiC-MOS | Netzwerk mit intrinsischer Kollektor-Ba-sis-Rückkop-plung |
| [2] | 10 | keine Angabe | ~19 | 6,5 | 3,8 | 3700 | 120 GHz BiC-MOS | Durch-bruchsspan-nungsverdop-pler |
| [3] | 23 | keine Angabe | ~20 | 5 | 3,5 | 2500 | 72 GHz BiCMOS | |
| [4] | 40 | 32,2 | 13,6 | 5 | 1,5 | 1125 | 80 GHz HBT | verteilter Verstärker |
| [5] | 40 | 22 | 36 | 8 | 3,6 | 3600 | 0,18μm BiC-MOS HV-HBT | Hochspan-nungs-HBT-Kaskode |
| Erfindung | 40 | 33,7 | 13,0 | 5,5 | 3 | 1350 | 0,18μm 180 GHz BiCMOS | verbesserter Durch-bruchsspan-nungsverdop-pler |

[1] Li, D.U., et al.: 'Efficient breakdown voltage doubler for 10 Gbit/s SiGe modulator drivers', Electronics Letters, 2005, 41, (3), S. 126-127 [2] Mandegaran, S. et al.: 'A Breakdown Voltage Multiplier for High Voltage Swing Drivers', Solid-State Circuits, IEEE Journal of, 2007, 42, (2), S. 302-312 [3] Schmid, R., et al.: 'SiGe driver circuit with high output amplitude operating up to 23 Gb/s', Solid-State Circuits, IEEE Journal of, 1999, 34, (6), S. 886-891 [4] Schick, C., et al.: '40 Gbit/s differential distributed modulator driver realised in 80 GHz SiGe HBT process', Electronics Letters, 2009, 45, (8), S. 408-409 [5] Aroca, R.A., et al.: 'A Large Swing, 40-Gb/s SiGe BiCMOS Driver With Adjustable Pre-Emphasis for Data Transmission Over 75 Ω Coaxial Cable', Solid-State Circuits, IEEE Journal of, 2008, 43, (10), S. 2177-2186

**Patentansprüche**

1. Durchbruchsspannungsverdopplerschaltung, die eine symmetrische Schaltung mit einer ersten und einer zweiten Schaltungshälfte umfasst, wobei jede Schaltungshälfte umfasst:

   eine Ausgangsstufe mit einem ersten ($T_{13}$, $T_{13'}$) und einem zweiten Ausgangstransistor ($T_{14}$, $T_{14'}$) in einer derart gestapelten Konfiguration, dass der Emitter des ersten Ausgangstransistors ($T_{13}$, $T_{13'}$) mit dem Kollektor des zweiten Ausgangstransistors ($T_{14}$, $T_{14'}$)verbunden ist;
   eine Signalteilerstufe (A, A'), die mit dem Eingang der Durchbruchsspannungsverdopplerschaltung verbunden ist und über einen ersten Signalpfad mit der Basis des ersten Ausgangstransistors ($T_{13}$, $T_{13'}$) und über einen zweiten Signalpfad mit der Basis des zweiten Ausgangstransistors ($T_{14}$, $T_{14'}$) verbunden ist;
   wobei die Schaltung dafür ausgelegt ist, eine Ausgangsspannung gleichmäßig auf die beiden gestapelten Ausgangstransistoren ($T_{13}$, $T_{13'}$ und $T_{14}$, $T_{14'}$) zu verteilen, um eine Spannung bereitzustellen, welche die Durchbruchsspannung jedes einzelnen der Ausgangstransistoren ($T_{13}$, $T_{14}$, $T_{13'}$, $T_{14'}$) übersteigt,
   **dadurch gekennzeichnet, dass**
   der obere Signalpfad der ersten Schaltungshälfte mit dem unteren Signalpfad der zweiten Schaltungshälfte über einen ersten Koppelpfad eines Koppelnetzwerks (D) gekoppelt ist und der untere Signalpfad der ersten Schaltungshälfte der Schaltung mit dem oberen Signalpfad der zweiten Schaltungshälfte der Schaltung über einen zweiten Koppelpfad eines Koppelnetzwerks (D) gekoppelt ist.

2. Durchbruchsspannungsverdopplerschaltung, die eine symmetrische Schaltung mit einer ersten und einer zweiten Schaltungshälfte umfasst, wobei jede Schaltungshälfte umfasst:

   eine Ausgangsstufe mit einem ersten ($T_{13}$, $T_{13'}$) und einem zweiten Ausgangstransistor ($T_{14}$, $T_{14'}$) in einer derart gestapelten Konfiguration, dass der Emitter des ersten Ausgangstransistors ($T_{13}$, $T_{13'}$) mit dem Kollektor des zweiten Ausgangstransistors ($T_{14}$, $T_{14'}$) verbunden ist;
   eine Signalteilerstufe (A, A'), die mit dem Eingang der Durchbruchsspannungsverdopplerschaltung verbunden ist und über einen ersten Signalpfad mit dem ersten Ausgangstransistor ($T_{13}$, $T_{13'}$) und über einen zweiten Signalpfad mit dem zweiten Ausgangstransistor ($T_{14}$, $T_{14'}$) verbunden ist;
   wobei die Schaltung dafür ausgelegt ist, eine Ausgangsspannung gleichmäßig auf die beiden gestapelten Ausgangstransistoren ($T_{13}$, $T_{13'}$ und $T_{14}$, $T_{14'}$) zu verteilen, um eine Spannung bereitzustellen, welche die Durchbruchsspannung jedes einzelnen der Ausgangstransistoren ($T_{13}$, $T_{14}$, $T_{13'}$, $T_{14'}$) übersteigt,

   **dadurch gekennzeichnet, dass**
   jeweils der obere Signalpfad in jeder Schaltungshälfte mit dem unteren Signalpfad derselben Schaltungshälfte zwischen der Signalteilerstufe (A, A') und den Basen der Ausgangstransistoren ($T_{13}$, $T_{13'}$ und $T_{14}$, $T_{14'}$) über einen jeweiligen Koppelpfad gekoppelt ist.

3. Durchbruchsspannungsverdopplerschaltung nach Anspruch 1 oder 2, **dadurch gekennzeichnet, dass** jede Schaltungshälfte ferner eine erste Signalverarbeitungsstufe (B, B') in dem ersten Signalpfad umfasst.

4. Durchbruchsspannungsverdopplerschaltung nach Anspruch 1 oder 2 oder 3, **dadurch gekennzeichnet, dass** jede Schaltungshälfte ferner eine zweite Signalverarbeitungsstufe (C, C') in dem zweiten Signalpfad umfasst.

5. Durchbruchsspannungsverdopplerschaltung nach Anspruch 3 oder 4,
   **dadurch gekennzeichnet, dass** die ersten Signalverarbeitungsstufen (B, B') jeweils mindestens einen ersten Emitterfolger ($T_{11}$) enthalten, dessen Basis mit dem Kollektor eines Eingangstransistors verbunden ist und dessen Emitter mit der Basis des ersten Ausgangstransistors ($T_{13}$) verbunden ist, sowie eine erste Kompensationskapazität ($C_H$), die mit einem Knoten im oberen Signalpfad, insbesondere zwischen dem Emitter des Transistors ($T_{11}$) der Signalverarbeitungsstufe und der Basis des ersten Ausgangstransistors ($T_{13}$) und einem Knoten an einer Versorgungsspannung (Vcc) verbunden ist.

6. Durchbruchsspannungsverdopplerschaltung nach einem der Ansprüche 4 oder 5, **dadurch gekennzeichnet, dass** die zweiten Signalverarbeitungsstufen (C, C') jeweils mindestens einen zweiten Emitterfolger ($T_{12}$) enthalten, dessen Basis mit dem Emitter des Eingangstransistors verbunden ist und dessen Emitter mit der Basis des zweiten Ausgangstransistors ($T_{14}$) verbunden ist.

7. Durchbruchsspannungsverdopplerschaltung nach Anspruch 1 und einem der Ansprüche 3 bis 6, **dadurch gekenn-**

**zeichnet, dass** der erste Koppelpfad die Basis des ersten Ausgangtransistors ($T_{13}$) der ersten Schaltungshälfte mit der Basis des zweiten Ausgangtransistors ($T_{14'}$) der zweiten Schaltungshälfte verbindet und dass der zweite Koppelpfad die Basis des zweiten Ausgangtransistors ($T_{14}$) der ersten Schaltungshälfte mit der Basis des ersten Ausgangtransistors ($T_{13'}$) der zweiten Schaltungshälfte verbindet.

8. Durchbruchsspannungsverdopplerschaltung nach Anspruch 1 und einem der Ansprüche 5 oder 6, **dadurch gekennzeichnet, dass** der erste Koppelpfad die Basis des Emitterfolgers ($T_{11}$) des ersten Signalpfades der ersten Schaltungshälfte mit der Basis des zweiten Ausgangtransistors ($T_{14'}$) der zweiten Schaltungshälfte verbindet und dass der zweite Koppelpfad die Basis des zweiten Ausgangtransistors ($T_{14}$) der ersten Schaltungshälfte mit der Basis des Emitterfolgers ($T_{11'}$) des ersten Signalpfades der zweiten Schaltungshälfte verbindet.

9. Durchbruchsspannungsverdopplerschaltung nach Anspruch 2 und einem der Ansprüche 3 bis 6, **dadurch gekennzeichnet, dass** die Koppelpfade in jeder Schaltungshälfte jeweils die Basis des ersten Ausgangtransistors ($T_{13}$, $T_{13'}$) mit der Basis des zweiten Ausgangtransistors ($T_{14}$, $T_{14'}$) verbinden.

10. Durchbruchsspannungsverdopplerschaltung nach Anspruch 2 und einem der Ansprüche 5 oder 6, **dadurch gekennzeichnet, dass** die Koppelpfade in jeder Schaltungshälfte jeweils die Basis des Emitterfolgers ($T_{11}$, $T_{11'}$) des ersten Signalpfades mit der Basis des zweiten Ausgangtransistors ($T_{14}$, $T_{14'}$) verbinden.

11. Durchbruchsspannungsverdopplerschaltung nach einem der vorhergehenden Ansprüche, **dadurch gekennzeichnet, dass** die Koppelpfade je eine zweite Kompensationskapazität ($C_M$) enthalten.

12. Durchbruchsspannungsverdopplerschaltung nach einem der vorhergehenden Ansprüche, **dadurch gekennzeichnet, dass** die Signalteilerstufe (A, A'), mindestens einen Eingangstransistor ($T_{10}$) umfasst, dessen Kollektor mit dem ersten Signalpfad gekoppelt ist und dessen Emitter mit dem zweiten Signalpfad gekoppelt ist, sowie einen Lastwiderstand (RL2) an dem Kollektor.

13. Durchbruchsspannungsverdopplerschaltung nach einem der vorhergehenden Ansprüche, **dadurch gekennzeichnet, dass** die Signalteilerstufen (A, A') ferner jeweils einen Rückkopplungswiderstand ($R_F$) enthalten, der zwischen den Signaleingang und den Kollektor des Eingangstransistors ($T_{10}$, $T_{10'}$) geschaltet ist.

14. Durchbruchsspannungsverdopplerschaltung nach einem der vorhergehenden Ansprüche, **dadurch gekennzeichnet, dass** die Signalteilerstufen (A, A') ferner jeweils eine dritte Kompensationskapazität ($C_{M2}$) enthalten, die zwischen den Eingang der einen Schaltungshälfte und den Kollektor des Eingangstransistors ($T_{10}$, $T_{10'}$) der anderen Schaltungshälfte geschaltet ist, wobei die dritte Kompensationskapazität ($C_{M2}$) und die erste Kompensationskapazität ($C_H$) relativ zueinander derart dimensioniert sind, dass sie das Frequenzverhalten und die Anstiegszeiten der Knoten im oberen Signalpfad optimieren.

15. Integriertes Schaltungsbauelement, das eine Durchbruchsspannungsverdopplerschaltung nach einem der Ansprüche 1 bis 14 umfasst.

**Claims**

1. Breakdown voltage doubler circuit, which comprises a symmetrical circuit having a first and a second circuit half, wherein each circuit half comprises:

an output stage having a first ($T_{13}$, $T_{13'}$) and a second output transistor ($T_{14}$, $T_{14'}$) in a configuration that is stacked in such a way that the emitter of the first output transistor ($T_{13}$, $T_{13'}$) is connected to the collector of the second output transistor ($T_{14}$, $T_{14'}$);
a signal divider stage (A, A'), which is connected to the input of the breakdown voltage doubler circuit and is connected to the base of the first output transistor ($T_{13}$, $T_{13'}$) via a first signal path and to the base of the second output transistor ($T_{14}$, $T_{14'}$) via a second signal path;
wherein the circuit is designed to distribute an output voltage evenly over the two stacked output transistors ($T_{13}$, $T_{13'}$ and $T_{14}$, $T_{14'}$) in order to supply a voltage that exceeds the breakdown voltage of each individual output transistor ($T_{13}$, $T_{14}$, $T_{13'}$, $T_{14'}$),
**characterized in that**
the upper signal path of the first circuit half is coupled to the lower signal path of the second circuit half via a first coupling path of a coupling network (D) and the lower signal path of the first circuit half of the circuit is coupled to the upper signal path of the second circuit half of the circuit via a second coupling path of a coupling network (D).

2. Breakdown voltage doubler circuit, which comprises a symmetrical circuit having a first and a second circuit half, wherein each circuit half comprises:

an output stage having a first ($T_{13}$, $T_{13'}$) and a second output transistor ($T_{14}$, $T_{14'}$) in a configuration that is stacked in such a way that the emitter of the first output transistor ($T_{13}$, $T_{13'}$) is connected to the collector of the second output transistor ($T_{14}$, $T_{14'}$);
a signal divider stage (A, A'), which is connected to the input of the breakdown voltage doubler circuit and is connected to the first output transistor ($T_{13}$, $T_{13'}$) via a first signal path and to the second output transistor ($T_{14}$, $T_{14'}$) via a second signal path;
wherein the circuit is designed to distribute an output voltage evenly over the two stacked output transistors ($T_{13}$, $T_{13'}$ and $T_{14}$, $T_{14'}$) in order to supply a voltage that exceeds the breakdown voltage of each individual output transistor ($T_{13}$, $T_{14}$, $T_{13'}$, $T_{14'}$),
**characterized in that**
the upper signal path in each circuit half is coupled in each case to the lower signal path of the same circuit half between the signal divider stage (A, A') and the bases of the output transistors ($T_{13}$, $T_{13'}$ and $T_{14}$, $T_{14'}$) via a respective coupling path.

3. Breakdown voltage doubler circuit according to Claim 1 or 2, **characterized in that** each circuit half also comprises a first signal processing stage (B, B') in the first signal path.

4. Breakdown voltage doubler circuit according to Claim 1 or 2 or 3, **characterized in that** each circuit half also comprises a second signal processing stage (C, C') in the second signal path.

5. Breakdown voltage doubler circuit according to Claim 3 or 4, **characterized in that** the first signal processing stages (B, B') each contain at least one first emitter follower ($T_{11}$), the base of which is connected to the collector of an input transistor and the emitter of which is connected to the base of the first output transistor ($T_{13}$), and a first compensation capacitance ($C_H$), which is connected to a node in the upper signal path, in particular between the emitter of the transistor ($T_{11}$) of the signal processing stage and the base of the first output transistor ($T_{13}$) and to a node at a supply voltage (Vcc) .

6. Breakdown voltage doubler circuit according to either of Claims 4 and 5, **characterized in that** the second signal processing stages (C, C') each contain at least one second emitter follower ($T_{12}$), the base of which is connected to the emitter of the input transistor and the emitter of which is connected to the base of the second output transistor ($T_{14}$).

7. Breakdown voltage doubler circuit according to Claim 1 and one of Claims 3 to 6, **characterized in that** the first coupling path connects the base of the first output transistor ($T_{13}$) of the first circuit half to the base of the second output transistor ($T_{14'}$) of the second circuit half and **in that** the second coupling path connects the base of the second output transistor ($T_{14}$) of the first circuit half to the base of the first output transistor ($T_{13'}$) of the second circuit half.

8. Breakdown voltage doubler circuit according to Claim 1 and either of Claims 5 and 6, **characterized in that** the first coupling path connects the base of the emitter follower ($T_{11}$) of the first signal path of the first circuit half to the base of the second output transistor ($T_{14'}$) of the second circuit half and **in that** the second coupling path connects the base of the second output transistor ($T_{14}$) of the first circuit half to the base of the emitter follower ($T_{11'}$) of the first signal path of the second circuit half.

9. Breakdown voltage doubler circuit according to Claim 2 and one of Claims 3 to 6, **characterized in that** the coupling paths in each circuit half each connect the base of the first output transistor ($T_{13}$, $T_{13'}$) to the base of the second output transistor ($T_{14}$, $T_{14'}$).

10. Breakdown voltage doubler circuit according to Claim 2 and either of Claims 5 and 6, **characterized in that** the coupling paths in each circuit half each connect the base of the emitter follower ($T_{11}$, $T_{11'}$) of the first signal path to the base of the second output transistor ($T_{14}$, $T_{14'}$).

**11.** Breakdown voltage doubler circuit according to one of the preceding claims, **characterized in that** the coupling paths each contain a second compensation capacitance ($C_M$).

**12.** Breakdown voltage doubler circuit according to one of the preceding claims, **characterized in that** the signal divider stage (A, A') comprises at least one input transistor ($T_{10}$), the collector of which is coupled to the first signal path and the emitter of which is coupled to the second signal path, and a load resistor (RL2) at the collector.

**13.** Breakdown voltage doubler circuit according to one of the preceding claims, **characterized in that** the signal divider stages (A, A') also each contain a feedback resistor ($R_F$), which is connected between the signal input and the collector of the input transistor ($T_{10}$, $T_{10'}$).

**14.** Breakdown voltage doubler circuit according to one of the preceding claims, **characterized in that** the signal divider stages (A, A') also each contain a third compensation capacitance ($C_{M2}$), which is connected between the input of one circuit half and the collector of the input transistor ($T_{10}$, $T_{10'}$) of the other circuit half, wherein the third compensation capacitance ($C_{M2}$) and the first compensation capacitance ($C_H$) are dimensioned relative to one another in such a way that they optimize the frequency response and the rise times of the nodes in the upper signal path.

**15.** Integrated circuit component, which comprises a breakdown voltage doubler circuit according to one of Claims 1 to 14.

**Revendications**

**1.** Circuit doubleur de tension de claquage, lequel comporte un circuit symétrique comprenant une première et une deuxième moitié de circuit, chaque moitié de circuit comportant :

un étage de sortie comprenant un premier ($T_{13}$, $T_{13'}$) et un deuxième transistor de sortie ($T_{14}$, $T_{14'}$) dans une configuration empilée de telle sorte que l'émetteur du premier transistor de sortie ($T_{13}$, $T_{13'}$) est relié au collecteur du deuxième transistor de sortie ($T_{14}$, $T_{14'}$) ;
un étage diviseur de signal (A, A') qui est relié à l'entrée du circuit doubleur de tension de claquage et relié à la base du premier transistor de sortie ($T_{13}$, $T_{13'}$) par le biais d'un premier trajet de signal et à la base du deuxième transistor de sortie ($T_{14}$, $T_{14'}$) par le biais d'un deuxième trajet de signal ;
le circuit étant conçu pour distribuer une tension de sortie de manière homogène sur les deux transistors de sortie ($T_{13}$, $T_{13'}$ et $T_{14}$, $T_{14'}$) empilés afin de délivrer une tension qui excède la tension de claquage de chacun des transistors de sortie ($T_{13}$, $T_{14}$, $T_{13'}$, $T_{14'}$) individuels,
**caractérisé en ce que**
le trajet de signal du haut de la première moitié de circuit est relié au trajet de signal du bas de la deuxième moitié de circuit par le biais d'un premier trajet de couplage d'un réseau de couplage (D) et le trajet de signal du bas de la première moitié de circuit est relié au trajet de signal du haut de la deuxième moitié de circuit par le biais d'un deuxième trajet de couplage d'un réseau de couplage (D).

**2.** Circuit doubleur de tension de claquage, lequel comporte un circuit symétrique comprenant une première et une deuxième moitié de circuit, chaque moitié de circuit comportant :

un étage de sortie comprenant un premier ($T_{13}$, $T_{13'}$) et un deuxième transistor de sortie ($T_{14}$, $T_{14'}$) dans une configuration empilée de telle sorte que l'émetteur du premier transistor de sortie ($T_{13}$, $T_{13'}$) est relié au collecteur du deuxième transistor de sortie ($T_{14}$, $T_{14'}$) ;
un étage diviseur de signal (A, A') qui est relié à l'entrée du circuit doubleur de tension de claquage et relié au premier transistor de sortie ($T_{13}$, $T_{13'}$) par le biais d'un premier trajet de signal et au deuxième transistor de sortie ($T_{14}$, $T_{14'}$) par le biais d'un deuxième trajet de signal ;
le circuit étant conçu pour distribuer une tension de sortie de manière homogène sur les deux transistors de sortie ($T_{13}$, $T_{13'}$ et $T_{14}$, $T_{14'}$) empilés afin de délivrer une tension qui excède la tension de claquage de chacun des transistors de sortie ($T_{13}$, $T_{14}$, $T_{13'}$, $T_{14'}$) individuels,
**caractérisé en ce que**
le trajet de signal du haut respectif dans chaque moitié de circuit est relié au trajet de signal du bas de la même moitié de circuit entre les étages diviseurs de signal (A, A') et les bases des transistors de sortie ($T_{13}$, $T_{13'}$ et $T_{14}$, $T_{14'}$) par le biais d'un trajet de couplage respectif.

**3.** Circuit doubleur de tension de claquage selon la revendication 1 ou 2, **caractérisé en ce que** chaque moitié de circuit comporte en outre un premier étage de traitement de signal (B, B') dans le premier trajet de signal.

**4.** Circuit doubleur de tension de claquage selon la revendication 1 ou 2 ou 3, **caractérisé en ce que** chaque moitié de circuit comporte en outre un deuxième étage de traitement de signal (C, C') dans le deuxième trajet de signal.

**5.** Circuit doubleur de tension de claquage selon la revendication 3 ou 4, **caractérisé en ce que** les premiers étages de traitement de signal (B, B') contiennent respectivement au moins un premier émetteur-suiveur ($T_{11}$) dont la base est reliée au collecteur d'un transistor d'entrée et dont l'émetteur est relié à la base du premier transistor de sortie ($T_{13}$), ainsi qu'un premier condensateur de compensation ($C_H$) qui est relié à un noeud dans le trajet de signal du haut, notamment entre l'émetteur du transistor ($T_{11}$) de l'étage de traitement de signal et la base du premier transistor de sortie ($T_{13}$), et à un noeud au niveau d'une tension d'alimentation (Vcc) .

**6.** Circuit doubleur de tension de claquage selon l'une des revendications 4 ou 5, **caractérisé en ce que** les deuxièmes étages de traitement de signal (C, C') contiennent respectivement au moins un deuxième émetteur-suiveur ($T_{12}$) dont la base est reliée à l'émetteur du transistor d'entrée et dont l'émetteur est relié à la base du deuxième transistor de sortie ($T_{14}$).

**7.** Circuit doubleur de tension de claquage selon la revendication 1 et l'une des revendications 3 à 6, **caractérisé en ce que** le premier trajet de couplage relie la base du premier transistor de sortie ($T_{13}$) de la première moitié de circuit à la base du deuxième transistor de sortie ($T_{14'}$) de la deuxième moitié de circuit et **en ce que** le deuxième trajet de couplage relie la base du deuxième transistor de sortie ($T_{14}$) de la première moitié de circuit à la base du premier transistor de sortie ($T_{13'}$) de la deuxième moitié de circuit.

**8.** Circuit doubleur de tension de claquage selon la revendication 1 et l'une des revendications 5 ou 6, **caractérisé en ce que** le premier trajet de couplage relie la base de l'émetteur-suiveur ($T_{11}$) du premier trajet de signal de la première moitié de circuit à la base du deuxième transistor de sortie ($T_{14'}$) de la deuxième moitié de circuit et **en ce que** le deuxième trajet de couplage relie la base du deuxième transistor de sortie ($T_{14}$) de la première moitié de circuit à la base de l'émetteur-suiveur ($T_{11'}$) de la deuxième moitié de circuit.

**9.** Circuit doubleur de tension de claquage selon la revendication 2 et l'une des revendications 3 à 6, **caractérisé en ce que** les trajets de couplage dans chaque moitié de circuit relient respectivement la base du premier transistor de sortie ($T_{13}$, $T_{13'}$) à la base du deuxième transistor de sortie ($T_{14}$, $T_{14'}$).

**10.** Circuit doubleur de tension de claquage selon la revendication 2 et l'une des revendications 5 ou 6, **caractérisé en ce que** les trajets de couplage dans chaque moitié de circuit relient respectivement la base de l'émetteur-suiveur ($T_{11}$, $T_{11'}$) à la base du deuxième transistor de sortie ($T_{14}$, $T_{14'}$).

**11.** Circuit doubleur de tension de claquage selon l'une des revendications précédentes, **caractérisé en ce que** les trajets de couplage contiennent respectivement un deuxième condensateur de compensation ($C_M$).

**12.** Circuit doubleur de tension de claquage selon l'une des revendications précédentes, **caractérisé en ce que** l'étage diviseur de signal (A, A') comporte au moins un transistor d'entrée ($T_{10}$) dont le collecteur est connecté au premier trajet de signal et dont l'émetteur est connecté au deuxième trajet de signal, ainsi qu'une résistance de charge (RL2) sur le collecteur.

**13.** Circuit doubleur de tension de claquage selon l'une des revendications précédentes, **caractérisé en ce que** les étages diviseurs de signal (A, A') contiennent en outre respectivement une résistance de contre-réaction ($R_F$) qui est branchée entre l'entrée de signal et le collecteur du transistor d'entrée ($T_{10}$, $T_{10'}$).

**14.** Circuit doubleur de tension de claquage selon l'une des revendications précédentes, **caractérisé en ce que** les étages diviseurs de signal (A, A') contiennent en outre respectivement un troisième condensateur de compensation ($C_{M2}$) qui est branché ente l'entrée d'une moitié de circuit et le collecteur du transistor d'entrée ($T_{10}$, $T_{10'}$) de l'autre moitié de circuit, le troisième condensateur de compensation ($C_{M2}$) et le premier condensateur de compensation ($C_H$) étant dimensionnés l'un par rapport à l'autre de telle sorte qu'ils optimisent le comportement en fréquence et les temps de montée des noeuds dans le trajet de signal du haut.

**15.** Composant de circuit intégré qui comporte un circuit doubleur de tension de claquage selon l'une des revendications 1 à 14.

Fig. 1 (Stand der Technik)

Fig. 2 (Stand der Technik)

Fig. 3

19

**Fig. 4**

**Fig.5**

**Fig. 6**

Fig. 7

Fig. 8

**Fig. 9**

EP 2 385 627 B1

**Fig. 10**

**Fig. 11**

**Fig. 12**

(a)

(b)

**Fig. 13**

**Fig. 14**

**Fig. 15**

**Fig. 16**

**Fig. 17**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7321242 B2

- US 20050258866 A1, Mandegaran

**In der Beschreibung aufgeführte Nicht-Patentliteratur**

- **GRENS, C.M. ; CRESSLER, J.D. ; JOSEPH, A.J.** On Common- Base Avalanche Instabilities in SiGe HBTs. *Electron Devices, IEEE Transactions on,* 2008, vol. 55 (6), 1276-1285
- **VEENSTRA, H. ; HURKX, G.A.M. ; VAN GOOR, D. ; BREKELMANS, H. ; LONG, J.R.** Analyses and design of bias circuits tolerating output voltages above BV. *Solid-State Circuits, IEEE Journal of,* 2005, vol. 40 (10), 2008-2018
- **LI, D.U. ; TSAI, C.M.** Efficient breakdown voltage doubler for 10 Gbit/s SiGe modulator drivers. *Electronics Letters,* 2005, vol. 41 (3), 126-127
- A Breakdown Voltage Multiplier for High Voltage Swing Drivers. *Solid-State Circuits, IEEE Journal of,* 2007, vol. 42 (2), 302-312
- **TIETZE, U. ; SCHENK, C.** Halbleiter-Schaltungstechnik. Springer, 2002
- **LI, D.U. et al.** Efficient breakdown voltage doubler for 10 Gbit/s SiGe modulator drivers. *Electronics Letters,* 2005, vol. 41 (3), 126-127

- **MANDEGARAN, S. et al.** A Breakdown Voltage Multiplier for High Voltage Swing Drivers. *Solid-State Circuits, IEEE Journal of,* 2007, vol. 42 (2), 302-312
- **SCHMID, R. et al.** SiGe driver circuit with high output amplitude operating up to 23 Gb/s. *Solid-State Circuits, IEEE Journal of,* 1999, vol. 34 (6), 886-891
- **SCHICK, C. et al.** 40 Gbit/s differential distributed modulator driver realised in 80 GHz SiGe HBT process. *Electronics Letters,* 2009, vol. 45 (8), 408-409
- **AROCA, R.A. et al.** A Large Swing, 40-Gb/s SiGe BiCMOS Driver With Adjustable Pre-Emphasis for Data Transmission Over 75 Ω Coaxial Cable. *Solid-State Circuits, IEEE Journal of,* 2008, vol. 43 (10), 2177-2186